# EUROPEAN PATENT APPLICATION

(11) **EP 4 804 773 A1**
(43) Date of publication of application: **09.09.2026**
(21) Application number: 26162963.8
(22) Date of filing: 06.03.2026
(51) Int. Cl.: H10K 59/122, G06F 3/044, H10K 59/35, H10K 59/38, H10K 59/40, H10K 59/65, H10K 59/80, H10K 59/131

(54) **ELECTRONIC DEVICE**

(30) Priority: 07.03.2025 KR 20250030093; 21.04.2025 KR 20250051726
(71) Applicant: Samsung Display Co., Ltd., Yongin-si, Gyeonggi-do (KR)
(72) Inventor: Lee, Eunggyu, Yongin-si, Gyeonggi-do (KR); Ban, Sodam, Yongin-si, Gyeonggi-do (KR)
(74) Representative: Gulde & Partner

(57) **Abstract**

Provided is an electronic device (10, ED, ED-a) including a display panel (DP) including a base layer (SUB) including an active region (DM-AA) and a transmission region (DM-E), a pixel unit (PXU) including pixels (PX), a pixel defining film (PDL) including openings (PDL-OP), and an encapsulation layer (TFE) covering the pixels (PX), an input sensing layer (ISP) disposed on the encapsulation layer (TFE), and a color filter layer (CML) disposed on the input sensing layer (ISP) and including first to third color filters (CF-R, CF-B, CF-G) that transmit light of different colors, wherein the first to third color filters (CF-R, CF-B, CF-G) include first to third holes (BI-R, BI-B, BI-G) defining a transmission hole (BIP) that that is around the input sensing layer (ISP) in the transmission region (DM-E), and a first width (WD-R) of the first hole (BI-R) of the first color filter (CF-R) that transmits red light is smaller than a second width (WD-B) of the second hole (BI-B) of the second color filter (CF-B) that transmits blue light and a third width (WD-G) of the third hole (BI-G) of the third color filter (CF-G) that transmits green light. (WD-B/WD_G > WD-R)

## Description

### BACKGROUND

The present disclosure relates to an electronic device, and more particularly, to an electronic device including a display panel below which an electronic module may be disposed.

Electronic devices are activated according to electrical signals. An electronic device may include devices composed of various electronic components, such as a display unit configured to display an image or a sensing unit configured to sense an external input. The electronic components may be electrically connected to each other by variously arranged signal lines. Recently, electronic devices in which an electronic module is disposed below an active region are being developed.

### SUMMARY

The present disclosure provides an electronic device with an increased degree of design freedom in the transmission region of a display panel which may overlap an electronic module.

The present disclosure also provides an electronic device in which the transmittance of the transmission region is improved.

An embodiment of the present disclosure provides an electronic device including: a display panel including a base layer including an active region, a transmission region surrounded by the active region, and a peripheral region adjacent to the active region, a pixel unit disposed on the base layer and including pixels, each pixel of the pixels including a transistor and a light-emitting element connected to the transistor, a pixel defining film including openings, wherein any one of the openings is around at least a portion of a first electrode included in the light-emitting element, and an encapsulation layer covering the pixels; a driving unit mounted on the display panel and transmitting an electrical signal to the display panel; an input sensing layer disposed on the encapsulation layer; and a color filter layer disposed on the input sensing layer and including first to third color filters configured to transmit light of different colors, wherein: the first to third color filters include first to third holes respectively defining a transmission hole that is at least partially around the input sensing layer in the transmission region; and a width of the first hole of the first color filter configured to transmit red light is smaller than a width of the second hole of the second color filter configured to transmit blue light and a width of the third hole of the third color filter configured to transmit green light.

In an embodiment, the first color filter may cover an upper surface of the second color filter and a side surface of the second color filter, which defines the second hole, and the third color filter may be disposed on an upper surface of the first color filter and expose a portion of the upper surface of the first color filter.

In an embodiment, the exposed portion of the upper surface of the first color filter may have a width of about 1 µm to about 2 µm.

In an embodiment, the first color filter may cover an upper surface of the third color filter and a side surface of the third color filter, which defines the third hole, and the second color filter may be disposed on an upper surface of the first color filter and expose a portion of the upper surface of the first color filter.

In an embodiment, the second color filter may be disposed on an upper surface of the first color filter and expose a portion of the upper surface of the first color filter, and the third color filter may be disposed on an upper surface of the second color filter and expose a portion of the upper surface of the second color filter.

In an embodiment, the third color filter may be disposed on the second color filter, the first color filter may be disposed on the second color filter, and the first color filter may cover a side surface of the second color filter, wherein the side surface of the second color filter defines the second hole, and a side surface of the third color filter, wherein the side surface of the third filter defines the third hole.

In an embodiment, the width of the first hole may be about 5 µm to about 14 µm.

In an embodiment, the light-emitting element may not be disposed in an opening at least partially aligned with the transmission hole among the openings, and a width between a side surface of the pixel defining film, which defines the opening at least partially aligned with the transmission hole, and a side surface of the first color filter, which defines the first hole, may be about 1 µm to about 2 µm.

In an embodiment, on a plane, the transmission hole may have a shape of either a circle or a polygon.

In an embodiment, the pixels included in the pixel unit may include a first pixel configured to generate the red light, may include a second pixel configured to generate the blue light, and may include a (3-1)-th pixel and a (3-2)-th pixel configured to generate the green light.

In an embodiment, the first pixel and the second pixel may be spaced apart from each other along the first direction, and the (3-1)-th pixel and the (3-2)-th pixel may be spaced apart from each other along a second direction crossing the first direction with the first pixel and the second pixel interposed therebetween.

In an embodiment, the pixel unit may be provided in plurality, and the pixel units may be arranged along the first direction and the second direction.

In an embodiment, the transmission hole may be provided in plurality, wherein any one of the transmission holes may be disposed between two pixel units adjacent thereto along the first direction and the second direction, and the other one of the transmission holes may be disposed inside one pixel unit.

In an embodiment, on a plane, the openings may be circular.

In an embodiment, the first color filter may be disposed on the first pixel, the second color filter may be disposed on the second pixel, and the third color filter may be disposed on the (3-1)-th and (3-2)-th pixels.

In an embodiment, the first to third color filters may be stacked on the input sensing layer that may overlap the pixel defining film.

In an embodiment, the encapsulation layer may include a first inorganic layer covering the light-emitting elements, may include a second inorganic layer disposed above the first inorganic layer, and may include an organic layer disposed between the first inorganic layer and the second inorganic layer.

In an embodiment, the input sensing layer may include a first sensing insulating layer directly disposed on the second inorganic layer, may include a first conductive layer disposed on the first sensing insulating layer, may include a second sensing insulating layer disposed on the first sensing insulating layer and covering the first conductive layer, may include a second conductive layer disposed on the second sensing insulating layer, and may include a third sensing insulating layer disposed on the second sensing insulating layer and covering the second conductive layer.

In an embodiment, the electronic device may further include an overcoat layer disposed on the color filter layer which may be in contact with the input sensing layer exposed by the transmission hole.

In an embodiment, the electronic device may further include an electronic module disposed below the transmission region, wherein the electronic module may include at least any one of a camera, a speaker, a light sensor, or a heat sensor.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present disclosure.

### BRIEF DESCRIPTION OF THE FIGURES

The accompanying drawings are included to provide a further understanding of the inventive concept, and are incorporated in and constitute a part of this specification. The drawings illustrate embodiments of the inventive concept and, together with the description, serve to explain principles of the inventive concept.
FIG. 1A is a block diagram of an electronic device according to an embodiment of the inventive concept.
FIG. 1B illustrates schematic diagrams of electronic devices according to various embodiments of the inventive concept.
FIG. 2A is a perspective view of an electronic device according to an embodiment of the inventive concept.
FIG. 2B is a perspective view of the electronic device according to an embodiment of the inventive concept.
FIG. 2C is a perspective view of the electronic device according to an embodiment of the inventive concept.
FIG. 2D is a perspective view of the electronic device according to an embodiment of the inventive concept.
FIG. 2E is a perspective view of an electronic device according to an embodiment of the inventive concept.
FIG. 2F is a perspective view of the electronic device according to an embodiment of the inventive concept.
FIG. 3 is an exploded perspective view of an electronic device according to an embodiment of the inventive concept.
FIG. 4 is a cross-sectional view illustrating a portion of a display module according to an embodiment of the inventive concept.
FIG. 5A is a plan view of the display module according to an embodiment of the inventive concept.
FIG. 5B is an equivalent circuit diagram of a pixel according to an embodiment of the inventive concept.
FIG. 6 is a cross-sectional view of the display module according to an embodiment of the inventive concept.
FIG. 7 is a cross-sectional view of a region corresponding to a transmission hole in the display module according to an embodiment of the inventive concept.
FIG. 8 is a plan view of a transmission region according to an embodiment of the inventive concept.
FIGS. 9A to 9C are plan views illustrating a color filter according to an embodiment of the inventive concept.
FIGS. 10 to 12 are cross-sectional views illustrating transmission holes in display modules according to an embodiment of the inventive concept.
FIG. 13 is a plan view of a pixel unit according to an embodiment of the inventive concept.

### DETAILED DESCRIPTION

In this specification, it will be understood that when an element (or region, layer, portion, etc.) is referred to as being "on", "connected to" or "coupled to" another element, it can be directly on, connected or coupled to the other element, or intervening elements may be present.

Like reference numerals refer to like elements throughout. In addition, in the drawings, the thicknesses, ratios, and dimensions of elements are exaggerated for effective description of the technical contents. As used herein, the term "and/or" includes any and all combinations that the associated configurations can define.

Although the terms first, second, etc. may be used herein to describe various components, these components should not be limited by these terms. These terms are used only to distinguish one component from another component. For example, without departing from the scope of the present disclosure, a first component may be referred to as a second component, and similarly, a second component may also be referred to as a first component. Singular expressions include plural expressions unless the context clearly indicates otherwise.

In addition, terms, such as "below", "lower", "above", "upper" and the like, are used herein for ease of description to describe one element's relation to another element(s) as illustrated in the figures. The above terms are relative concepts and are described based on the directions indicated in the drawings.

It will be understood that the terms "include" and/or "have", when used in this specification, specify the presence of stated features, integers, steps, operations, elements, components and/or groups thereof, but do not preclude the presence or addition of one or more other features, integers, steps, operations, elements, components, or groups thereof.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the inventive concept will be described with reference to the accompanying drawings.

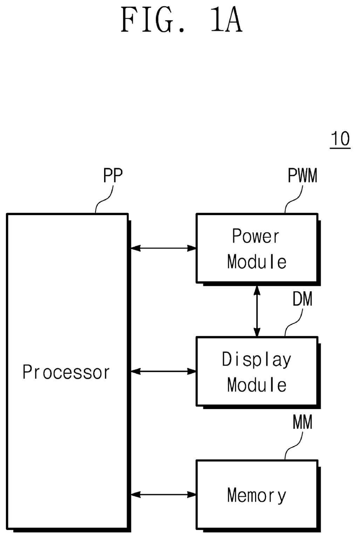

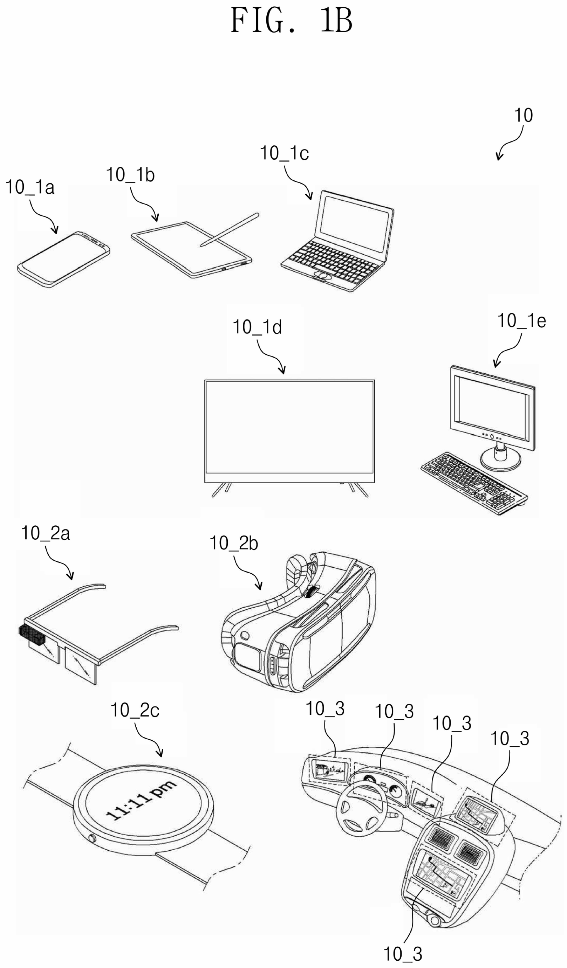

FIG. 1A is a block diagram of an electronic device according to an embodiment of the inventive concept. FIG. 1B illustrates schematic diagrams of electronic devices according to various embodiments of the inventive concept.

Referring to FIG. 1A, an electronic device 10 according to an embodiment of the inventive concept may include a display module DM, a processor PP, a memory MM, and a power module PWM. The processor PP, memory MM, and power module PWM may be include in a driving unit.

The processor PP may include at least one of a central processing unit (CPU), an application processor (AP), a graphic processing unit (GPU), a communication processor (CP), an image signal processor ISP, or a controller. The processor PP may include one or more processors. The one or more processors may be configured to carry out operations such as executing an application individually, as a collective or a subset of the collective. For example, two out of three processors may operate together to execute an application.

The memory MM may store data information for the operation of the processor PP or the display module DM. When the processor PP executes an application stored in the memory MM, an image data signal and/or an input control signal may be transmitted to the display module DM, and the display module DM may process the received signal and output image information through a display screen.

The power module PWMs may include a power supply module, such as a power adapter or a battery device, and a power conversion module configured to convert power supplied by the power supply module and generate power for the operation of the electronic device 10. As such the driving unit may transmit electrical signals to the display module DM.

At least one of the components of the electronic device 10 described above may be included in display devices according to the embodiments described below. In addition, some of the individual modules functionally included in one module may be included in a display device, while others may be provided separately from the display device. For example, the display module DM may be included in the display device, while the processor PP, the memory MM, and the power module PWM may be provided in the form of other devices within the electronic device 10, rather than within the display device.

Referring to FIG. 1B, various electronic devices to which display devices according to embodiments of the inventive concept are applied may include not only electronic devices for displaying images, such as a smart phone 10_1a, a tablet PC 10_1b, a laptop 10_1c, a TV 10_1d, and a desktop monitor 10_1e, but also wearable electronic devices including a display module, such as smart glasses 10_2a, a head-mounted display 10_2b, and a smart watch 10_2c, as well as automotive electronic devices 10_3 including a display module, such as a center information display (CID) disposed on a vehicle's instrument panel, center fascia, or dashboard, and a room mirror display.

Hereinafter, features applicable to the present disclosure may be applied to all of the above-described electronic devices, and in particular, based on the above-described smartphone 10_1a, foldable electronic devices ED and ED-a will be described as examples. The features of the present disclosure to be described below may be applied not only to the foldable electronic devices ED and ED-a but also to flat electronic devices.

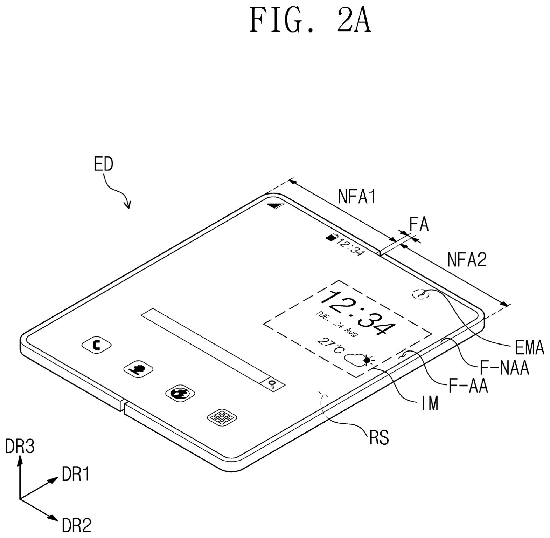

FIGS. 2A to 2F are perspective views illustrating an electronic device according to an embodiment of the inventive concept.

FIG. 2A is a perspective view of an electronic device ED in an unfolded state according to an embodiment of the inventive concept. The electronic device ED according to an embodiment of the inventive concept may be activated according to an electrical signal. For example, the electronic device ED may be a mobile phone, a tablet, a car navigation system, a game console, or a wearable device, but the embodiment of the inventive concept is not limited thereto. FIGS. 2A to 2F illustrate a foldable electronic device ED or ED-a as an example. The foldable electronic device ED or ED-a according to an embodiment of the inventive concept may be the aforementioned smartphone 10_la (mobile phone, etc.).

The electronic device ED may include a first display surface FS defined by a first direction DR1 and a second direction DR2 crossing the first direction DR1. The electronic device ED may provide an image IM to a user through the first display surface FS. The electronic device ED may display the image IM toward a third direction DR3 on the first display surface FS parallel to each of the first direction DR1 and the second direction DR2.

In this specification, the first direction DR1 and the second direction DR2 may be orthogonal to each other, and the third direction DR3 may be a normal direction to a plane defined by the first direction DR1 and the second direction DR2. The thickness direction of the electronic device ED may be a direction parallel to the third direction DR3. The front (or upper) surface and the rear (or lower) surface of the electronic device ED may oppose each other in the third direction DR3, and the normal direction of each of the front (or upper) surface and the rear (or lower) surface may be parallel to the third direction DR3.

The front (or upper) surface refers to a surface close to the first display surface FS, and the rear (or lower) surface refers to a surface spaced apart from the first display surface FS. In addition, the rear (or lower) surface refers to a surface close to a second display surface RS to be described later. The term 'upper side' (or upper portion) refers to a direction approaching the first display surface FS, and the term 'lower side' (or lower portion) refers to a direction away from the first display surface FS.

The term 'cross section' of components refers to a surface parallel to the third direction DR3, which is the thickness direction, and the term 'plane' refers to a surface perpendicular to the third direction DR3, which is the thickness direction. The plane refers to a surface defined by the first direction DR1 and the second direction DR2.

The electronic device ED may sense an external input applied from the outside. The external input may include various forms of inputs provided from the outside of the electronic device ED. For example, the external input may include not only a contact by a part of a body, such as a user's hand, but also an external input (e.g., hovering) applied in proximity to the electronic device ED or at a predetermined distance therefrom. In addition, the external input may take various forms, such as force, pressure, temperature, and light.

The electronic device ED may include a first display surface FS and a second display surface RS. The first display surface FS may include a first active region F-AA and a first peripheral region F-NAA.

The second display surface RS may be defined as a surface opposing at least a portion of the first display surface FS. That is, the second display surface RS may be defined as a portion of the rear surface of the electronic device ED in a state in which the electronic device ED is unfolded.

The first active region F-AA may be activated according to an electrical signal. The first active region F-AA may be a region in which an image IM may be displayed and various forms of external inputs may be sensed.

The first peripheral region F-NAA may be a region in which an image IM is not displayed. The first peripheral region F-NAA may be adjacent to the first active region F-AA. The first peripheral region F-NAA may have a predetermined color. The first peripheral region F-NAA may surround the first active region F-AA. Accordingly, the shape of the first active region F-AA may be substantially defined by the first peripheral region F-NAA. However, this is exemplary, and the first peripheral region F-NAA may be disposed adjacent to only one side of the first active region F-AA, or may be omitted.

Various electronic modules may be disposed in a transmission region EMA. For example, the electronic modules may include at least any one of a camera, a speaker, a light sensor, or a heat sensor. The transmission region EMA may sense an external subject received through the display surfaces FS and RS or provide a sound signal, such as a voice, to the outside through the display surfaces FS and RS. An electronic module may include a plurality of components and is not limited to any one embodiment.

According to the present disclosure, since the transmission region EMA is disposed inside the first active region F-AA, the light transmittance thereof may be relatively higher than that of the first active region F-AA. As a transmission hole is defined and formed by passing through color filters included in a display module DM that will be described later, the transmission region EMA may have relatively higher transmittance than adjacent regions. A detailed description thereof will be provided later.

The transmission region EMA may be surrounded by the first peripheral region F-NAA. However, this is exemplary and is not limited to any one embodiment. For example, the transmission region EMA may be surrounded by the first active region F-AA and the first peripheral region F-NAA and disposed inside the first active region F-AA. In this case, in a region overlapping the transmission region EMA, a hole formed by passing therethrough may be defined.

In FIG. 2A, the shape of the transmission region EMA is illustrated as a circle but is not limited thereto. For example, on a plane, the shape of the transmission region EMA may be at least any one of a bar shape, a polygonal shape, or an elliptical shape.

The electronic device ED according to an embodiment of the inventive concept may be divided into at least one folding region FA and a plurality of non-folding regions NFA1 and NFA2 extending from the folding region FA. For example, a first non-folding region NFA1, a folding region FA, and a second non-folding region NFA2 may be defined along the second direction DR2.

The electronic device ED may be divided into the first non-folding region NFA1 and the second non-folding region NFA2 spaced apart from each other in the second direction DR2 with the folding region FA interposed therebetween. For example, the first non-folding region NFA1 may be disposed on one side of the folding region FA in the second direction DR2, and the second non-folding region NFA2 may be disposed on the other side of the folding region FA in the second direction DR2.

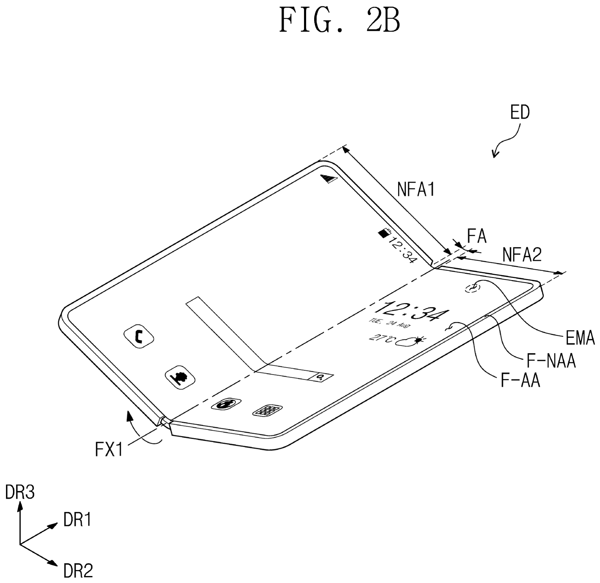

Referring to FIG. 2B, the electronic device ED according to an embodiment of the inventive concept may be folded about a first folding axis FX1 extending in the first direction DR1. In a state in which the electronic device ED is folded, the folding region FA may have a predetermined curvature and a predetermined radius of curvature. When the electronic device ED is folded about the first folding axis FX1, the electronic device ED may be transformed into an in-folded state so that the first non-folding region NFA1 and the second non-folding region NFA2 may face each other and the first display surface FS may not be exposed to the outside. In this specification, a state in which the electronic device ED is folded or being folded may be defined as a 'first mode'. A state in which the electronic device ED is unfolded or being unfolded may be defined as a 'second mode'. Accordingly, when the first mode is in progress, one portion of the first active region F-AA overlapping the first non-folding region NFA1 and the other portion thereof overlapping the second non-folding region NFA2 may face each other.

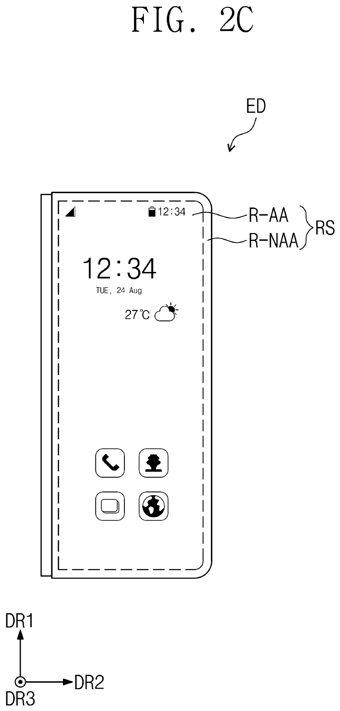

Referring to FIG. 2C, in a state in which the electronic device ED according to an embodiment of the inventive concept is in-folded, the second display surface RS may be viewed by a user. In this case, the second display surface RS may include a second active region R-AA that displays an image. The second active region R-AA may be activated according to an electrical signal. The second active region R-AA may be a region in which an image may be displayed and various forms of external inputs may be sensed.

The second display surface RS may include a second peripheral region R-NAA. The second peripheral region R-NAA may be adjacent to the second active region R-AA. The second peripheral region R-NAA may have a predetermined color. The second peripheral region R-NAA may surround the second active region R-AA. In addition, although not illustrated, the electronic device ED may further include a transmission region in which the electronic module including various components is disposed also on the second display surface RS, and the electronic device ED is not limited to any one embodiment.

According to an embodiment of the inventive concept, when the electronic device ED is in an in-folded state, the distance between the first non-folded region NFA1 and the second non-folded region NFA2 may be smaller than the radius of a circle defined by the radius of curvature of the folding region FA. In this case, the folding region FA may be folded into a dumbbell shape, and the distance between the first non-folding region NFA1 and the second non-folding region NFA2 may be further reduced. Therefore, in a folded state, the electronic device ED may be provided in a slimmer form.

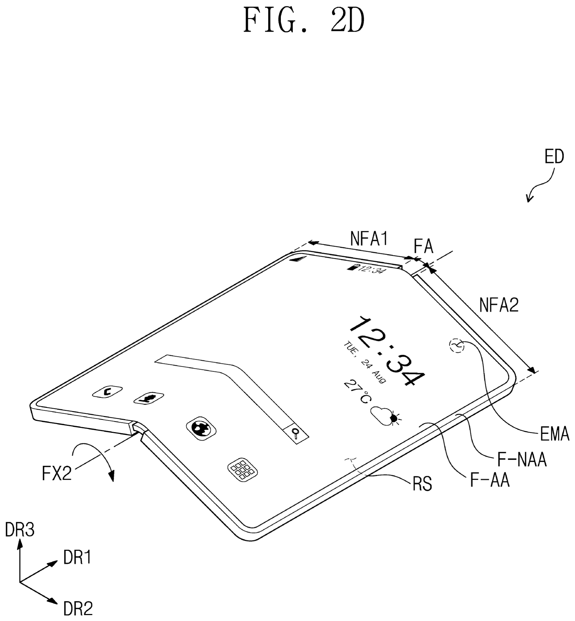

Referring to FIG. 2D, the electronic device ED according to an embodiment of the inventive concept may be folded about a second folding axis FX2 extending in the first direction DR1. The electronic device ED may be folded about the second folding axis FX2 to be transformed into an out-folded state in which the first display surface FS is exposed to the outside. In an embodiment of the inventive concept, the electronic device ED may be configured such that in-folding and out-folding operations are alternately repeated from an unfolding operation, but the embodiment of the inventive concept is not limited thereto.

FIGS. 2A to 2D exemplarily illustrate that the electronic device ED is folded about one folding axis FX1 or FX2, but the number of folding axes and the number of non-folding regions according to the folding axes are not limited thereto. For example, the electronic device ED may be folded about a plurality of folding axes so that portions of the first display surface FS and the second display surface RS face each other. In addition, the first and second folding axes FX1 and FX2 are illustrated as being parallel to the long sides of the electronic device ED, but the embodiment of the inventive concept is not limited thereto, and the first and second folding axes FX1 and FX2 may be parallel to the short sides of the electronic device ED.

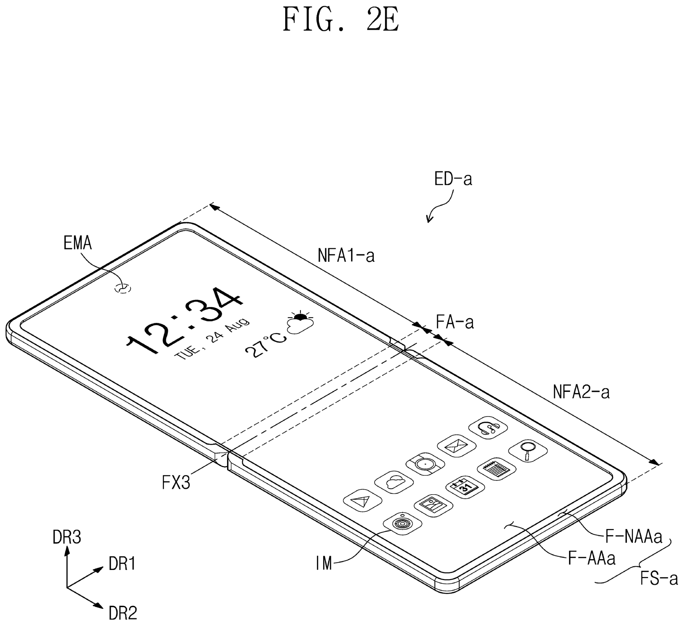

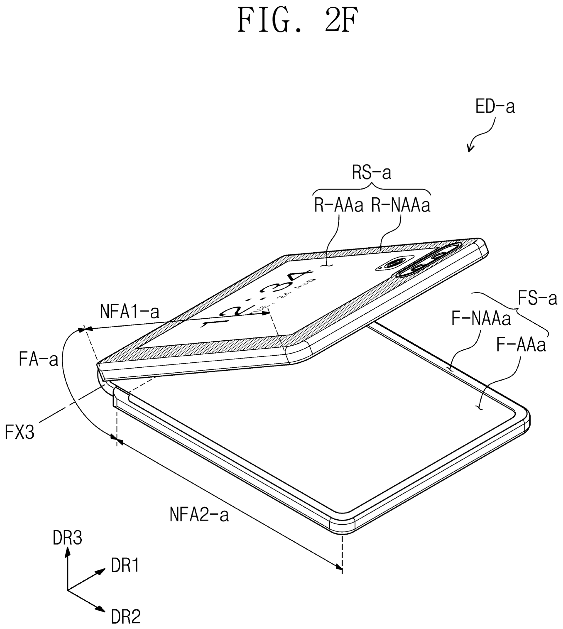

FIG. 2E is a perspective view of an electronic device according to an embodiment of the inventive concept. FIG. 2F is a perspective view of the electronic device according to an embodiment of the inventive concept.

FIGS. 2E and 2F are perspective views illustrating an electronic device ED-a according to an embodiment of the inventive concept. FIG. 2E is a perspective view illustrating an unfolded state of the electronic device ED-a. FIG. 2F is a perspective view illustrating a folding operation of the electronic device ED-a.

Referring to FIG. 2E, the electronic device ED-a may be folded about a third folding axis FX3 extending along the first direction DR1. The third folding axis FX3 may extend along the first direction DR1 parallel to the extension direction of the short sides of the electronic device ED-a.

The electronic device ED-a may include a first non-folding region NFA1-a, a folding region FA-a, and a second non-folding region NFA2-a arranged along the second direction DR2. The first non-folding region NFA1-a and the second non-folding region NFA2-a may be spaced apart from each other with the folding region FA-a interposed therebetween.

The folding region FA-a may be folded about the third folding axis FX3. In a state in which the electronic device ED-a is folded, the folding region FA-a may have a predetermined curvature and a predetermined radius of curvature. The first non-folding region NFA1-a and the second non-folding region NFA2-a may face each other, and the electronic device ED-a may be in-folded so that the display surface FS is not exposed to the outside.

Referring to FIG. 2E, in an embodiment of the inventive concept, when the electronic device ED-a is in an unfolded state (i.e., when it is not folded), a first display surface FS-a may be visible to a user. As described with reference to FIGS. 2A to 2D, the first display surface FS-a of the electronic device ED-a may include a first active region F-AAa and a first peripheral region F-NAAa. The first active region F-AAa may be a region in which an image IM may be displayed in an unfolded state or while being unfolded and various forms of external inputs may be sensed.

Referring to FIG. 2F, a second display surface RS-a may be visible to a user in a state in which the electronic device ED-a according to an embodiment of the inventive concept is in-folded according to the first mode. The second display surface RS-a may include a second active region R-AAa and a second peripheral region R-NAAa. The second peripheral region R-NAAa may have a predetermined color. The second peripheral region R-NAAa may surround the second active region R-AAa. According to the present disclosure, when the first mode is in progress, one portion of the first active region F-AAa overlapping the first non-folded region NFA1-a and the other portion thereof overlapping the second non-folded region NFA2-a may face each other.

According to this embodiment, a transmission region EMA disposed inside the first active region F-AAa and having a higher light transmittance than the first active region F-AAa may be included.

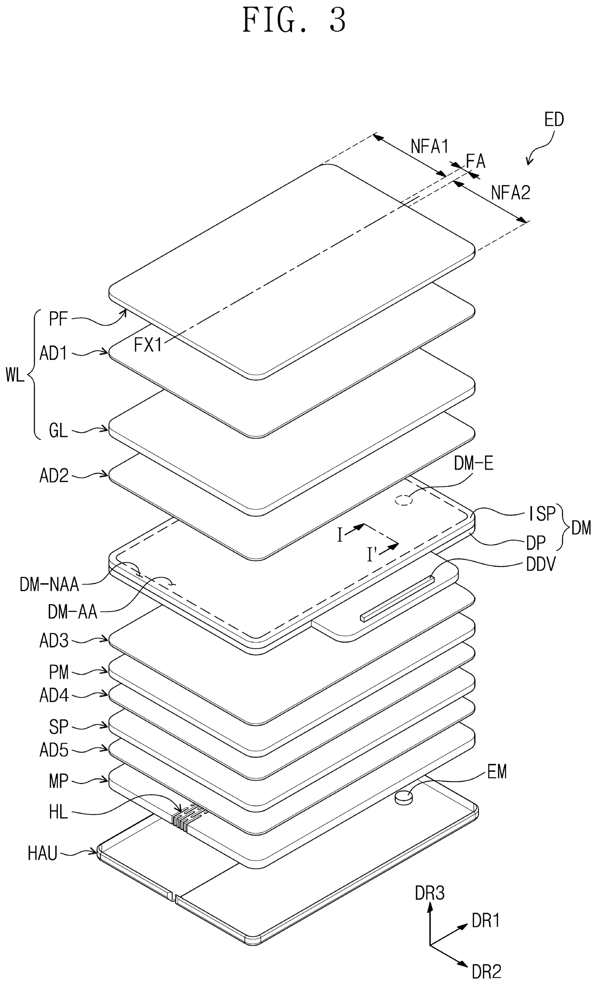

FIG. 3 is an exploded perspective view of an electronic device according to an embodiment of the inventive concept. FIG. 3 is an exploded perspective view of the electronic device ED described in FIGS. 2A to 2D.

Referring to FIG. 3, the electronic device ED may include a window WL, a display module DM, a lower film PM, a support plate SP, a lower plate MP, and a housing HAU.

The housing HAU may be coupled to the window WL to define the appearance of the electronic device ED. The housing HAU may include a material having relatively high rigidity. For example, the housing HAU may include a plurality of frames and/or support plates made of glass, plastic, or metal. The housing HAU may provide a predetermined accommodation space. The display module DM may be accommodated within the accommodation space and protected from external impact. The lower plate MP may also be made from a material having relatively high rigidity and may provide further rigidity and include holes HL in the folding area FA providing further to structural strength in the folding area FA while still allowing the device to be folded.

According to an embodiment of the inventive concept, the housing HAU overlapping the folding region FA may further include a hinge structure or the like to guide the folding operation of the electronic device ED. In addition, the housing HAU may include a first portion overlapping the first non-folding region NFA1 and a second portion overlapping the second non-folding region NFA2 in order to guide the folding operation of the electronic device ED, wherein the first and second portions may be connected to each other by the hinge structure.

The display module DM may be disposed below the window WL. The display module DM may be activated according to an electrical signal. An active region DM-AA of the display module DM may be activated to display an image IM (see FIG. 2A) on the first active region F-AA (see FIG. 2A) and the second active region R-AA (see FIG. 2C) of the electronic device ED. A peripheral region DM-NAA may surround the active region DM-AA.

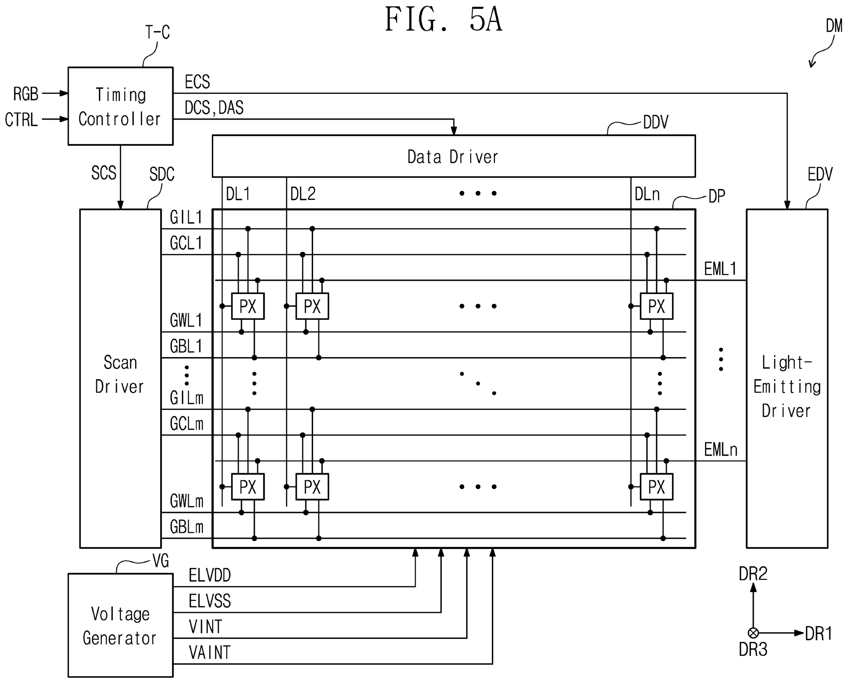

The image IM (see FIG. 2A) generated by the display module DM may be transmitted through the window WL and visible to a user. The window WL may include a polymer substrate or a glass substrate. The display module DM may include a display panel DP and an input sensing layer ISP directly disposed on the display panel DP. A data driver DDV may be mounted on one side of the display module DM. The region on which the data driver DDV is mounted may be housed in the housing HAU in a bent state. The data driver DDV may transmit an electrical signal to pixels. The data driver DDV may be connected to the pixels through data lines DL1 to DLn illustrated in FIG. 5A. In some embodiments the Driving unit may include the data driver DDV.

An electronic module EM overlapping an active region DM-AA may be included below the display module DM. The electronic module EM may include at least any one of the camera, the speaker, the light sensor, and the heat sensor described above.

The display module DM may include a transmission region DM-E corresponding to the transmission region EMA (see FIG. 2A) of the electronic device ED. The transmission region DM-E may be disposed inside the active region DM-AA.

The window WL according to an embodiment of the inventive concept may include a protective layer PF and a window base layer GL. The protective layer PF and the window base layer GL may include an optically transparent insulating material. In this embodiment, the window base layer GL may include polyethylene terephthalate (PET). The protective layer PF may be disposed on the window base layer GL. The protective layer PF may be a functional layer configured to protect the upper surface of the window base layer GL. The protective layer PF may include a polymer film. The protective layer PF may include an anti-fingerprint coating agent, a hard coating agent, an anti-static agent, and the like.

The protective layer PF and the window base layer GL may be bonded to each other by a first adhesive layer AD1. Each of the first to fifth adhesive layers AD1-ADS to be described later may include a typical adhesive, such as a pressure sensitive adhesive (PSA), an optically clear adhesive (OCA), or an optical clear resin (OCR), and is not limited to any one embodiment. In the electronic device ED according to an embodiment of the inventive concept, at least one of the first to fifth adhesive layers AD1-ADS may be omitted.

According to an embodiment of the inventive concept, a light-blocking pattern may be disposed between the first adhesive layer AD1 and the protective layer PF. The light-blocking pattern may be formed on a portion adjacent to an edge of the lower surface of the protective layer PF by a method such as printing or coating. The light-blocking pattern is not limited to any particular material as long as it is capable of absorbing light.

The lower film PM may protect the lower portion of the display module DM. The lower film PM may include a flexible plastic material. For example, the lower film PM may include polyethylene terephthalate.

However, FIG. 3 is an example of a stacked structure of the foldable electronic device ED, and the features of the display module DM according to the present disclosure may be applied to electronic devices having different stacked structures.

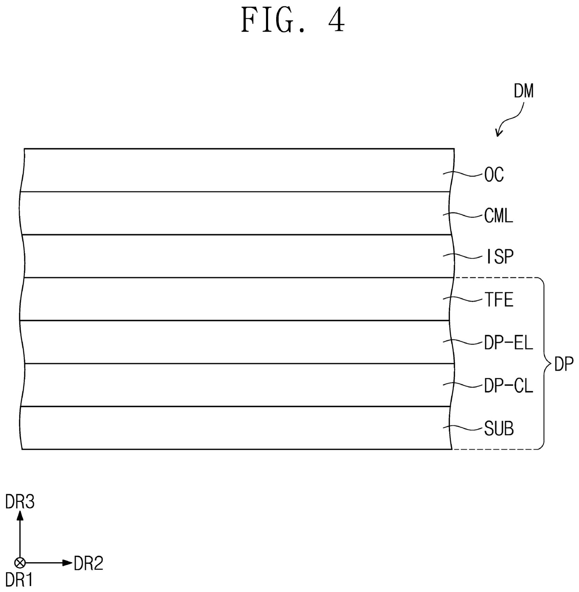

FIG. 4 is a cross-sectional view illustrating a portion of a display module according to an embodiment of the inventive concept.

Referring to FIG. 4, the display module DM may include a display panel DP, an input sensing layer ISP, a color filter layer CML, and an overcoat layer OC.

The display module DM may include a display panel DP and an input sensing layer ISP disposed on the display panel DP. The display panel DP may be a component that substantially generates an image. The display panel DP may be a light-emitting display panel. For example, the display panel DP may be an organic light-emitting display panel, an inorganic light-emitting display panel, a micro LED display panel, a micro OLED display panel, or a nano LED display panel.

The display panel DP may include a base layer SUB, a circuit layer DP-CL, a display element layer DP-EL, and an encapsulation layer TFE that are sequentially stacked. Unlike what is illustrated, a functional layer may be further included between two adjacent layers among the base layer SUB, the circuit layer DP-CL, the display element layer DP-EL, and the encapsulation layer TFE.

The base layer SUB may provide a base surface on which the circuit layer DP-CL is disposed. The base layer SUB may be a flexible substrate capable of bending, folding, rolling, etc. The base layer SUB may be a glass substrate, a metal substrate, a polymer substrate, etc. However, the embodiment of the inventive concept is not limited thereto, and the base layer SUB may include an inorganic layer, an organic layer, or a composite material layer.

The base layer SUB may include a single layer or multiple layers. For example, the base layer SUB may include a first synthetic resin layer, a multi-layer or single-layer inorganic layer, and a second synthetic resin layer disposed on the multi-layer or single-layer inorganic layer. Each of the first synthetic resin layer and the second synthetic resin layer may include a polyimide-based resin.

In addition, each of the first synthetic resin layer and the second synthetic resin layer may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, or a perylene-based resin. In this specification, an X"-based resin means a resin that includes a functional group of "X". For example, a methacrylic-based resin is a resin that includes a methacrylic group e.g., polymethyl methacrylate is an example of a methacrylic resin.

The circuit layer DP-CL may be disposed on the base layer SUB. The circuit layer DP-CL may include an insulating layer, a semiconductor pattern, a conductive pattern, a signal line, and the like. The display element layer DP-EL may be disposed on the circuit layer DP-CL. The display element layer DP-EL may include a light-emitting element (not illustrated). For example, the light-emitting element may include an organic light-emitting material, an inorganic light-emitting material, an organic-inorganic light-emitting material, a quantum dot, a quantum rod, a micro LED, or a nano LED.

The encapsulation layer TFE may be disposed on the display element layer DP-EL. The encapsulation layer TFE may protect the display element layer DP-EL from moisture, oxygen, and foreign substances such as dust particles. The encapsulation layer TFE may include at least one inorganic layer. For example, the encapsulation layer TFE may include an inorganic layer, an organic layer, and an inorganic layer that are sequentially stacked.

The input sensing layer ISP may be disposed on the display panel DP. The input sensing layer ISP may be disposed directly on the encapsulation layer TFE. Unlike this, an adhesive member may be disposed between the input sensing layer ISP and the display panel DP.

In this specification, an expression "One component is disposed directly on another component" means that a third component is not disposed between them. In other words, the expression "One component is disposed directly on another component" means that the one component is in contact with the other component.

The input sensing layer ISP may sense an external input, change the external input into a predetermined input signal, and provide the input signal to the display panel DP. For example, the input sensing layer ISP may be a touch sensing layer that senses a touch. The input sensing layer ISP may sense a direct touch of a user, an indirect touch of a user, a direct touch of an object, or an indirect touch of an object.

The input sensing layer ISP may sense at least one of the position or intensity (pressure) of a touch applied from the outside. The input sensing layer ISP may have a variety of structures or be composed of various materials and is not limited to any one embodiment. For example, the input sensing layer ISP may sense an external input by a capacitance method. The display panel DP may receive an input signal from the input sensing layer ISP and generate an image corresponding to the input signal.

The color filter layer CML may be directly disposed on the input sensing layer ISP. The color filter layer CML may include a plurality of color filters configured to transmit light of a specific wavelength range and block light outside the wavelength range. Each of the color filters includes a base resin and dye and/or pigment dispersed in the base resin. The base resin is a medium, in which dye and/or pigment are dispersed, and may be made of various resin compositions that may generally be referred to as binders.

The overcoat layer OC may be disposed on the color filter layer CML. The overcoat layer OC may compensate for a step difference formed by components disposed below the overcoat layer OC. Since the overcoat layer OC provides a flat surface, the window WL may be stably disposed on the overcoat layer OC.

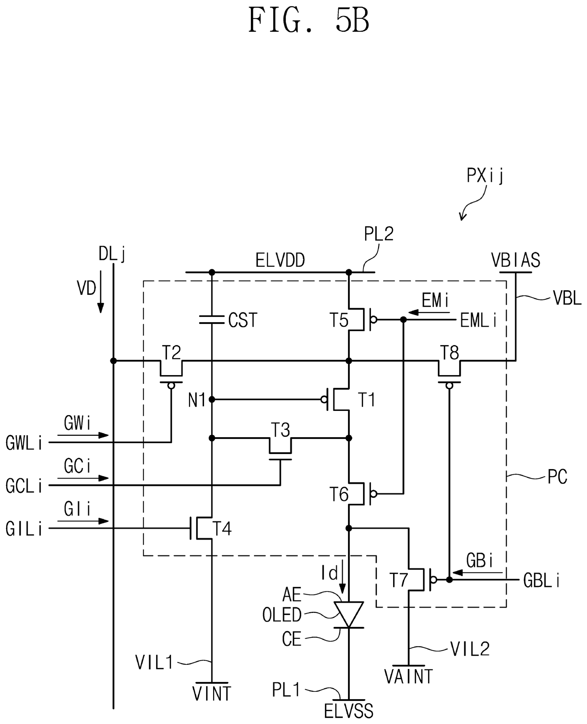

FIG. 5A is a plan view of the display module according to an embodiment of the inventive concept. FIG. 5B is an equivalent circuit diagram of a pixel according to an embodiment of the inventive concept.

Referring to FIG. 5A, the electronic device ED or ED-a may include a display panel DP, a timing controller T-C, a scan driver SDC, a data driver DDV, a light-emitting driver EDV, and a voltage generator VG.

The display panel DP may include a plurality of scan lines GIL1 to GILm, GCL1 to GCLm, GWL1 to GWLm, and GBL1 to GBLm, a plurality of light-emitting lines EML1 to EMLm, a plurality of data lines DL1 to DLn, and a plurality of pixels PX, wherein m and n are natural numbers greater than 0.

According to an embodiment of the inventive concept, the pixels PX may be electrically connected to the scan lines GIL1 to GILm, GCL1 to GCLm, GWL1 to GWLm, and GBL1 to GBLm, the light-emitting lines EML1 to EMLm, and the data lines DL1 to DLn, respectively.

The scan lines GIL1 to GILm, GCL1 to GCLm, GWL1 to GWLm, and GBL1 to GBLm may include a plurality of initialization scan lines GIL1 to GILm, a plurality of compensation scan lines GCL1 to GCLm, a plurality of write scan lines GWL1 to GWLm, and a plurality of bias scan lines GBL1 to GBLm.

Each of the pixels PX may be connected to a corresponding one of the initialization scan lines GIL1 to GILm, a corresponding one of the compensation scan lines GCL1 to GCLm, a corresponding one of the write scan lines GWL1 to GWLm, and a corresponding one of the bias scan lines GBL1 to GBLm.

The scan lines GIL1 to GILm, GCL1 to GCLm, GWL1 to GWLm, and GBL1 to GBLm may be connected to the scan driver SDC, extend in the first direction DR1, and be arranged in the second direction DR2. The light-emitting lines EML1 to EMLm may be connected to the light-emitting driver EDV, extend in the first direction DR1, and be arranged in the second direction DR2. The data lines DL1 to DLn may be connected to the data driver DDV, extend in the second direction DR2, and be arranged in the first direction DR1.

The scan driver SDC, the light-emitting driver EDV, and the data driver DDV may be substantially disposed in the display module DM.

The timing controller T-C may receive an image signal RGB and a control signal CTRL. The timing controller T-C may generate an image data signal DAS by converting the data format of the image signal RGB so as to meet the interface specifications with the data driver DDV. The timing controller T-C may output a scan control signal SCS, a data control signal DCS, and a light-emitting control signal ECS in response to the control signal CTRL.

The voltage generator VG may generate voltages necessary for the operation of the display panel DP. The voltage generator VG may generate a first driving voltage ELVSS, a second driving voltage ELVDD, a first initialization voltage VINT, and a second initialization voltage VAINT. The first driving voltage ELVSS, the second driving voltage ELVDD, the first initialization voltage VINT, and the second initialization voltage VAINT may be applied to the pixels PX.

The scan driver SDC may receive a scan control signal SCS from the timing controller T-C. The scan driver SDC may output scan signals to the scan lines GIL1 to GILm, GCL1 to GCLm, GWL1 to GWLm, and GBL1 to GBLm in response to the scan control signal SCS. The scan signals may be applied to the pixels PX through the scan lines GIL1 to GILm, GCL1 to GCLm, GWL1 to GWLm, and GBL1 to GBLm.

The data driver DDV may receive a data control signal DCS and an image data signal DAS from the timing controller T-C. The data driver DDV may convert the image data signal DAS into data signals and output them. The data signals may be defined as analog voltages corresponding to the grayscale levels of the image data signal DAS. The data signals may be applied to the pixels PX through the data lines DL1 to DLn.

The light-emitting driver EDV may receive a light-emitting control signal ECS from the timing controller T-C. The light-emitting driver EDV may output light-emitting signals to the light-emitting lines EML1 to EMLm in response to the light-emitting control signal ECS. The light-emitting signals may be applied to the pixels PX through the light-emitting lines EML1 to EMLm.

The pixels PX may receive data voltages in response to the scan signals. The pixels PX may display an image by emitting light having a luminance corresponding to the data voltages in response to the light-emitting signals.

FIG. 5B illustrates an equivalent circuit of any one of the pixels illustrated in FIG. 5A. FIG. 5B illustrates a pixel PXij connected to a j-th data line DLj, i-th scan lines GWLi, GCLi, GILi, and GBLi, and an i-th light-emitting line EMLi, wherein i and j are natural numbers greater than 0.

Referring to FIG. 5B, the pixel PXij may include a pixel circuit PC and a light-emitting element OLED connected to the pixel circuit PC. The pixel circuit PC may drive the light-emitting element OLED.

The pixel circuit PC may include a plurality of transistors T1 to T8 and a capacitor CST. The transistors T1 to T8 and the capacitor CST may control the amount of driving current Id flowing through the light-emitting element OLED. The light emitting element OLED may generate light having a predetermined luminance according to the amount of current supplied.

An i-th write scan line GWLi may receive an i-th write scan signal GWi, and an i-th compensation scan line GCLi may receive an i-th compensation scan signal GCi. An i-th initialization scan line GILi may receive an i-th initialization scan signal GIi, and an i-th bias scan line GBLi may receive an i-th bias scan signal GBi. The i-th light-emitting line EMLi may receive an i-th light-emitting signal EMi.

The pixel PXij may be connected to the j-th data line DLj, the i-th write scan line GWLi, the i-th compensation scan line GCLi, the i-th initialization scan line GILi, the i-th bias scan line GBLi, the i-th light-emitting line EMLi, a first initialization line VIL1, a second initialization line VIL2, a bias line VBL, and first and second power lines PL1 and PL2.

The first initialization line VIL1 may receive the first initialization voltage VINT, and the second initialization line VIL2 may receive the second initialization voltage VAINT. The bias line VBL may receive a bias voltage VBIAS. The first power line PL1 may receive the first driving voltage ELVSS, and the second power line PL2 may receive the second driving voltage ELVDD. According to an embodiment of the inventive concept, the first power line PL1 may receive the second driving voltage ELVDD, and the second power line PL2 may receive the first driving voltage ELVSS, and according to the disclosure, the names of the first and second power lines may be changed.

Each of the transistors T1 to T8 may include a source electrode, a drain electrode, and a gate electrode. Hereinafter, in FIG. 5B, for convenience, any one of the source electrode and the drain electrode is defined as a first electrode, and the other one thereof is defined as a second electrode. In addition, the gate electrode is defined as a control electrode.

The transistors T1 to T8 may include first to eighth transistors T1 to T8. The first, second, and fifth to eighth transistors T1, T2, and T5 to T8 may be PMOS transistors. The third and fourth transistors T3 and T4 may be NMOS transistors.

The first transistor T1 may be defined as a driving transistor, and the second transistor T2 may be defined as a switching transistor. The third transistor T3 may be defined as a compensation transistor. The fourth transistor T4 and the seventh transistor T7 may be defined as initialization transistors. The fifth transistor T5 and the sixth transistor T6 may be defined as light-emitting control transistors. The eighth transistor T8 may be defined as a bias transistor.

The light-emitting element OLED may be defined as an organic light-emitting element. The light-emitting element OLED may include a first electrode AE and a second electrode CE. The first electrode AE may receive the second driving voltage ELVDD through the sixth, first, and fifth transistors T6, T1, and T5. The second driving voltage ELVDD may be applied to the pixel circuit PC through the second power line PL2.

The second electrode CE may receive the first driving voltage ELVSS having a lower level than the second driving voltage ELVDD. The first driving voltage ELVSS may be applied to the second electrode CE through the first power line PL1.

The first transistor T1 may be disposed between the fifth transistor T5 and the sixth transistor T6 and connected to them. The first transistor T1 may be connected to the second power line PL2 through the fifth transistor T5 and to the first electrode AE through the sixth transistor T6.

The first transistor T1 may include a first electrode connected to the second power line PL2 through the fifth transistor T5, a second electrode connected to the first electrode AE through the sixth transistor T6, and a control electrode connected to a first node N1.

The first electrode of the first transistor T1 may be connected to the fifth transistor T5, and the second electrode of the first transistor T1 may be connected to the sixth transistor T6. The first transistor T1 may control the amount of driving current Id flowing through the light-emitting element OLED according to the voltage of the first node N1, which is applied to the control electrode of the first transistor T1.

The second transistor T2 may be disposed between the first transistor T1 and the j-th data line DLj and connected to them. The second transistor T2 may include a first electrode connected to the j-th data line DLj, a second electrode connected to the first electrode of the first transistor T1, and a control electrode connected to the i-th write scan line GWLi.

The second transistor T2 may be turned on by the i-th write scan signal GWi applied through the i-th write scan line GWLi and electrically connect the j-th data line DLj and the first electrode of the first transistor T1 to each other. The second transistor T2 may perform a switching operation that provides a data voltage VD (corresponding to the aforementioned data signal), which is applied through the j-th data line DLj, to the first electrode of the first transistor T1.

The third transistor T3 may be connected to the second electrode of the first transistor T1 and the first node N1. The third transistor T3 may include a first electrode connected to the second electrode of the first transistor T1, a second electrode connected to the first node N1, and a control electrode connected to the i-th compensation scan line GCLi.

The third transistor T3 may be turned on by the i-th compensation scan signal GCi applied through the i-th compensation scan line GCLi and electrically connect the second electrode of the first transistor T1 and the control electrode of the first transistor T1 to each other. When the third transistor T3 is turned on, the first transistor T1 and the third transistor T3 may be connected to each other in a diode form.

The fourth transistor T4 may be connected to the first node N1. The fourth transistor T4 may include a first electrode connected to the first node N1, a second electrode connected to the first initialization line VIL1, and a control electrode connected to the i-th initialization scan line GILi. The fourth transistor T4 may be turned on by the i-th initialization scan signal GIi applied through the i-th initialization scan line GILi and provide the first initialization voltage VINT, which is applied through the first initialization line VIL1, to the first node N1.

The fifth transistor T5 may include a first electrode connected to the second power line PL2, a second electrode connected to the first electrode of the first transistor T1, and a control electrode connected to the i-th light-emitting line EMLi.

The sixth transistor T6 may include a first electrode connected to the second electrode of the first transistor T1, a second electrode connected to the first electrode AE, and a control electrode connected to the i-th light-emitting line EMLi.

The fifth transistor T5 and the sixth transistor T6 may be turned on by the i-th light-emitting signal EMi applied through the i-th light-emitting line EMLi. As the second driving voltage ELVDD is provided to the light-emitting element OLED by the turned-on fifth transistor T5 and sixth transistor T6, a driving current Id may flow through the light-emitting element OLED. Accordingly, the light-emitting element OLED may emit light.

The seventh transistor T7 may include a first electrode connected to the first electrode AE, a second electrode connected to the second initialization line VIL2, and a control electrode connected to the i-th bias scan line GBLi. The seventh transistor T7 may be turned on by the i-th bias scan signal GBi applied through the i-th bias scan line GBLi and provide the second initialization voltage VAINT, which is received through the second initialization line VIL2, to the first electrode AE of the light-emitting element OLED.

In an embodiment of the inventive concept, the second initialization voltage VAINT may have a level different from that of the first initialization voltage VINT, but the embodiment of the inventive concept is not limited thereto, and the second initialization voltage VAINT may have the same level as the first initialization voltage VINT.

The seventh transistor T7 may improve the black expression capability of the pixel PXij. When the seventh transistor T7 is turned on, a parasitic capacitor (not illustrated) of the light-emitting element OLED may be discharged. Therefore, during the implementation of black luminance, the light-emitting element OLED does not emit light due to the leakage current of the first transistor T1, thereby improving the black expression capability.

The capacitor CST may include a first electrode connected to the second power line PL2 and a second electrode connected to the first node N1. When the fifth transistor T5 and the sixth transistor T6 are turned on, the amount of current flowing through the first transistor T1 may be determined according to the voltage stored in the capacitor CST.

The eighth transistor T8 may include a first electrode connected to the bias line VBL, a second electrode connected to the first electrode of the first transistor T1, and a control electrode connected to the i-th bias scan line GBLi.

The eighth transistor T8 may be turned on by the i-th bias scan signal GBi and provide the bias voltage VBIAS, which is applied through the bias line VBL, to the first electrode of the first transistor T1. However, the transistors included in the pixel PXij are not limited thereto.

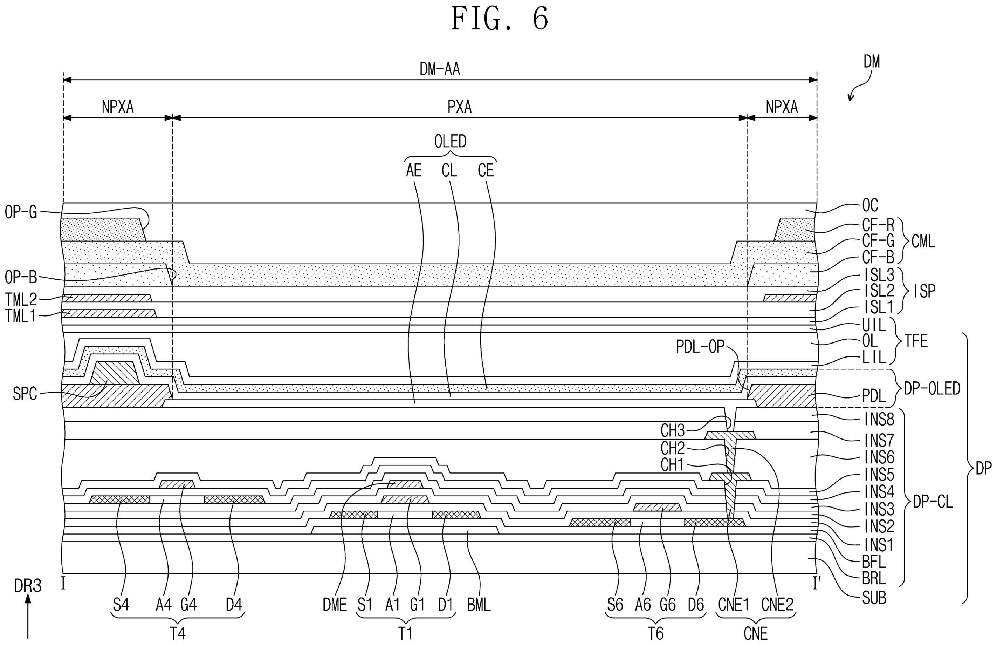

FIG. 6 is a cross-sectional view of the display module according to an embodiment of the inventive concept. FIG. 6 is a cross-sectional view of a region corresponding to one pixel disposed on the display panel DP. FIG. 6 is a cross-sectional view taken along line I-I' in FIG. 3.

Referring to FIG. 6, the light-emitting element OLED according to an embodiment of the inventive concept may include a first electrode AE, a second electrode CE, and a common layer CL. The common layer CL may include a hole control layer, an electron control layer, and a light-emitting layer.

The second electrode CE may be disposed above the first electrode AE, and the common layer CL may be disposed between the first electrode AE and the second electrode CE. The light-emitting element OLED according to an embodiment of the inventive concept may further include a protective layer disposed on the second electrode CE. The protective layer may include an organic material and prevent damage to components disposed below the protective layer in a subsequent process. According to an embodiment of the inventive concept, the protective layer may be omitted.

The second driving voltage ELVDD may be applied to the first electrode AE, and the first driving voltage ELVSS may be applied to the second electrode CE. Holes and electrons injected into the common layer CL may recombine to form excitons, and as the excitons transition to a ground state, the light-emitting element OLED may emit light. When the light-emitting element OLED emits light, an image may be displayed.

The first, fourth, and sixth transistors T1, T4, and T6 and the light-emitting element OLED may be disposed above the base layer SUB. The active region DM-AA of the display module DM may include a light-emitting region PXA and a non-light-emitting region NPXA adjacent to the light-emitting region PXA.

The base layer SUB may include glass or a flexible plastic material such as polyimide (PI). A circuit layer DP-CL, a display element layer DP-OLED, and an encapsulation layer TFE may be disposed above the base layer SUB. The circuit layer DP-CL may be disposed on the base layer SUB. The circuit layer DP-CL may include insulating layers and conductive patterns. The display element layer DP-OLED may include a light-emitting element OLED and a pixel defining film PDL. A spacer SPC may be disposed on the pixel defining film PDL.

A barrier layer BRL may be disposed on the base layer SUB. The barrier layer BRL may increase the bonding strength between the semiconductor patterns included in the transistors and the base layer SUB. The barrier layer BRL may include an inorganic material.

A metal layer BML may be disposed on the barrier layer BRL. The metal layer BML may overlap the first transistor T1. According to an embodiment of the inventive concept, the metal layer BML may receive a constant voltage. When the constant voltage is applied to the metal layer BML, a threshold voltage Vth of the first transistor T1 disposed above the metal layer BML may remain unchanged.

The metal layer BML may block light incident on the first transistor T1 from below the metal layer BML. The metal layer BML may include a reflective metal. According to an embodiment of the inventive concept, the metal layer BML may be omitted.

A buffer layer BFL may be disposed on the barrier layer BRL and cover the metal layer BML. The buffer layer BFL may include an inorganic material.

A semiconductor layer S1, A1, and D1 of the first transistor T1 and a semiconductor layer S6, A6, and D6 of the sixth transistor T6 may be disposed on the buffer layer BFL. The semiconductor layers S1, A1, D1, S6, A6, and D6 may include polysilicon. Without being limited thereto, however, the semiconductor layers S1, A1, D1, S6, A6, and D6 may include amorphous silicon.

The semiconductor layers S1, A1, D1, S6, A6, and D6 may be doped with an N-type dopant or a P-type dopant. The semiconductor layers S1, A1, D1, S6, A6, and D6 may include a highly doped region and a lightly doped region. The conductivity of the highly doped region may be greater than that of the lightly doped region, and the highly doped region may substantially serve as the source and drain electrodes of the first and sixth transistors T1 and T6. The lightly doped region may substantially correspond to the active (or channel) regions of the first and sixth transistors T1 and T6.

A first source region S1, a first channel region A1, and a first drain region D1 of the first transistor T1 may be formed from a semiconductor layer S1, A1, and D1. A sixth source region S6, a sixth channel region A6, and a sixth drain region D6 of the sixth transistor T6 may be formed from the semiconductor layer S6, A6, and D6. The first channel region A1 may be disposed between the first source region S1 and the first drain region D1. The sixth channel region A6 may be disposed between the sixth source region S6 and the sixth drain region D6.

A first insulating layer INS1 may be disposed on the buffer layer BFL to cover the semiconductor layers S1, A1, D1, S6, A6, and D6. A first gate electrode G1 (or control electrode) of the first transistor T1 and a sixth gate electrode G6 (or control electrode) of the sixth transistor T6 may be disposed on the first insulating layer INS1. When viewed on a plane, the first gate electrode G1 may overlap the first channel region A1, and the sixth gate electrode G6 may overlap the sixth channel region A6.

According to an embodiment of the inventive concept, the structures of the source region, the channel region, the drain region, and the gate electrode of each of the second, fifth, and seventh transistors T2, T5, and T7 may be substantially the same as those of the first and sixth transistors T1 and T6.

A second insulating layer INS2 may be disposed on the first insulating layer INS1 to cover the first and sixth gate electrodes G1 and G6. A dummy electrode DME may be disposed on the second insulating layer INS2. The dummy electrode DME may be disposed on the first gate electrode G1 and overlap the first gate electrode G1 when viewed on a plane. The dummy electrode DME may form the above-described capacitor together with the first gate electrode G1.

A third insulating layer INS3 may be disposed on the second insulating layer INS2 to cover the dummy electrode DME. A semiconductor layer S4, A4, and D4 of the fourth transistor T4 may be disposed on the third insulating layer INS3. The semiconductor layer S4, A4, and D4 may include an oxide semiconductor formed of a metal oxide. The oxide semiconductor may include a crystalline or amorphous oxide semiconductor.

The semiconductor layer S4, A4, and D4 may include a plurality of regions divided depending on whether or not the metal oxide is reduced. A region (hereinafter, referred to as a reduced region) in which the metal oxide is reduced may have higher conductivity than a region (hereinafter, referred to as a non-reduced region) in which the metal oxide is not reduced. The reduced region may substantially function as the source or drain electrode of the fourth transistor T4. The non-reduced region may substantially correspond to the active (or channel) region of the fourth transistor T4.

A fourth source region S4, a fourth channel region A4, and a fourth drain region D4 of the fourth transistor T4 may be formed from the semiconductor layer S4, A4, and D4. The fourth channel region A4 may be disposed between the fourth source region S4 and the fourth drain region D4.

A fourth insulating layer INS4 may be disposed on the third insulating layer INS3 to cover the semiconductor layer S4, A4, and D4. A fourth gate electrode G4 of the fourth transistor T4 may be disposed on the fourth insulating layer INS4. When viewed on a plane, the fourth gate electrode G4 may overlap the fourth channel region A4.

A fifth insulating layer INS5 may be disposed on the fourth insulating layer INS4 to cover the fourth gate electrode G4. Although not illustrated, the structures of the source region, channel region, drain region, and gate electrode of the third transistor T3 may be substantially the same as those of the fourth transistor T4.

The barrier layer BRL, the buffer layer BFL, and the first to fifth insulating layers INS1 to INS5 may include an inorganic material. For example, the barrier layer BRL, the buffer layer BFL, and the first to fifth insulating layers INS1 to INS5 may include either silicon oxide or silicon nitride, or one insulating layer may include multiple inorganic layers, and the inventive concept is not limited to any one embodiment. The multiple inorganic layers may have a structure in which layers including silicon nitride and silicon oxide are alternately stacked.

A connection electrode CNE may be disposed between the sixth transistor T6 and the light-emitting element OLED. The connection electrode CNE may electrically connect the sixth transistor T6 and the light-emitting element OLED to each other. The connection electrode CNE may include a first connection electrode CNE1 and a second connection electrode CNE2 disposed on the first connection electrode CNE1.

The first connection electrode CNE1 may be disposed on the fifth insulating layer INS5 and connected to the sixth drain region D6 through a first contact hole CH1 defined in the first to fifth insulating layers INS1 to INS5. A sixth insulating layer INS6 may be disposed on the fifth insulating layer INS5 to cover the first connection electrode CNE1.

The second connection electrode CNE2 may be disposed on the sixth insulating layer INS6. The second connection electrode CNE2 may be connected to the first connection electrode CNE1 through a second contact hole CH2 defined in the sixth insulating layer INS6.

A seventh insulating layer INS7 may be disposed on the sixth insulating layer INS6 to cover the second connection electrode CNE2. An eighth insulating layer INS8 may be disposed on the seventh insulating layer INS7 to cover the seventh insulating layer INS7. The sixth to eighth insulating layers INS6, INS7, and INS8 may include an organic material. According to an embodiment of the inventive concept, at least any one of the sixth to eighth insulating layers INS6, INS7, and INS8 may be omitted.

The first electrode AE of the light-emitting element OLED may be connected to the second connection electrode CNE2 through a third contact hole CH3 defined in the seventh and eighth insulating layers INS7 and INS8.

The pixel defining film PDL may be disposed on the eighth insulating layer INS8. An opening PDL-OP exposing at least a portion of the first electrode AE may be defined in the pixel defining film PDL. In this embodiment, the pixel defining film PDL may include an organic material. In addition, the pixel defining film PDL may have a predetermined color and is not limited to any one embodiment.

The common layer CL and the second electrode CE included in the light-emitting element OLED may be disposed on the pixel defining film PDL.

The encapsulation layer TFE may be disposed on and cover the light-emitting element OLED. The encapsulation layer TFE may include a first inorganic layer LIL, an organic layer OL, and a second inorganic layer UIL that are sequentially stacked. The first and second inorganic layers LIL and UIL may include an inorganic material and protect the pixels from moisture/oxygen. The organic layer OL may include an organic material and protect the pixels PX from foreign substances such as dust particles.

The input sensing layer ISP may be directly disposed on the encapsulation layer TFE. The input sensing layer ISP may include a first sensing insulating layer ISL1, a first conductive layer TML1, a second sensing insulating layer ISL2, a second conductive layer TML2, and a third sensing insulating layer ISL3.

The first sensing insulating layer ISL1 may be directly disposed on the second inorganic layer UIL. The first sensing insulating layer ISL1 may be an inorganic layer including at least any one of silicon nitride, silicon oxynitride, or silicon oxide. In an embodiment, the first sensing insulating layer ISL1 may be an organic layer including an epoxy-based resin, an acrylic-based resin, or an imide-based resin. The first sensing insulating layer ISL1 may have a single-layer structure or a multi-layer structure in which layers are sequentially stacked.

Each of the first conductive layer TML1 and the second conductive layer TML2 may have a single-layer structure or a multi-layer structure in which layers are stacked along the third direction DR3.

The single-layer conductive layer may include a metal layer or a transparent conductive layer. The metal layer may include molybdenum, silver, titanium, copper, aluminum, or an alloy thereof. The transparent conductive layer may include a transparent conductive oxide such as indium tin oxide (ITO), indium zinc oxide (IZO), zinc oxide (ZnO), or indium zinc tin oxide (IZTO). In addition, the transparent conductive layer may include a conductive polymer such as PEDOT, metal nanowire, graphene, and the like.

The multi-layer conductive layer may include metal layers. The metal layers may have a three-layer structure of, for example, titanium/aluminum/titanium. The multi-layer conductive layer may include at least one metal layer and at least one transparent conductive layer.

The second sensing insulating layer ISL2 may be disposed on the first sensing insulating layer ISL1 and cover the first conductive layer TML1. The second sensing insulating layer ISL2 may include an inorganic film. The inorganic film may include at least one of aluminum oxide, titanium oxide, silicon oxide, silicon nitride, silicon oxynitride, zirconium oxide, or hafnium oxide.

In an embodiment, the second sensing insulating layer ISL2 may include an organic film. The organic film may include at least any one of an acrylic-based resin, a methacrylic-based resin, polyisoprene, a vinyl-based resin, an epoxy-based resin, a urethane-based resin, a cellulose-based resin, a siloxane-based resin, a polyimide-based resin, a polyamide-based resin, or a perylene-based resin.

The third sensing insulating layer ISL3 may be disposed on the second sensing insulating layer ISL2 and cover the second conductive layer TML2. The second conductive layer TML2 may be provided as mesh lines overlapping the pixel defining film PDL. The third sensing insulating layer ISL3 may include an inorganic material. For example, the third sensing insulating layer ISL3 may include silicon nitride but is not particularly limited thereto.

The color filter layer CML may be directly disposed on the third sensing insulating layer ISL3. The color filter layer CML may include first to third color filters CF-R, CF-B, and CF-G.

Each of the first to third color filters CF-R, CF-B, and CF-G may transmit light of a specific wavelength range and block light outside the wavelength range. Therefore, light leaked into an adjacent light-emitting region PXA may be absorbed.

Each of the first to third color filters CF-R, CF-B, and CF-G includes a base resin and dye and/or pigment dispersed in the base resin. The base resin is a medium, in which dye and/or pigment are dispersed, and may be composed of various resin compositions that may generally be referred to as binders.

FIG. 6 exemplarily illustrates the first color filter CF-R disposed on the light-emitting element OLED that generates red light. The first color filter CF-R may transmit red light, the second color filter CF-B may transmit blue light, and the third color filter CF-G may transmit green light.

A second opening OP-B of the second color filter CF-B and a third opening OP-G of the third color filter CF-G may be defined in a region in which the first color filter CF-R is disposed. Therefore, the second color filter CF-B and the third color filter CF-G may not be disposed above the light-emitting element OLED that generates red light.

According to this embodiment, on the third sensing insulating layer ISL3 overlapping the pixel defining film PDL, there may be a structure in which the first to third color filters CF-R, CF-B, and CF-G are stacked. The region in which the first to third color filters CF-R, CF-B, and CF-G are stacked may have a black matrix function. Therefore, the region in which the first to third color filters CF-R, CF-B, and CF-G are stacked may prevent color mixing between adjacent regions. In addition, since the first to third color filters CF-R, CF-B, and CF-G are stacked to form a structure having a black matrix function, a process of forming a separate light-blocking pattern may be omitted.

An overcoat layer OC may be disposed on the color filter layer CML. The overcoat layer OC may include an organic material. The overcoat layer OC may provide a flat upper surface.

According to the present disclosure, the pixels PX may be disposed in the active region DM-AA and the transmission region DM-E described in FIG. 3. The arrangement structures of the pixels PX disposed in the active region DM-AA and the transmission region DM-E may be the same as or different from each other. The arrangement structures of the pixels PX disposed in the active region DM-AA and the transmission region DM-E will be described later.

The transmission region DM-E may have a higher light transmittance than the active region DM-AA. Accordingly, at least one of the components disposed in the transmission region DM-E may include a transmission hole BIP formed through the one component to increase light transmittance.

The cross-sectional structure of the pixels PX disposed in the transmission region DM-E may correspond to what is described in FIG. 6. In the transmission region DM-E, the region in which the pixels PX are disposed and the region in which the transmission hole BIP is disposed may be spaced apart from each other.

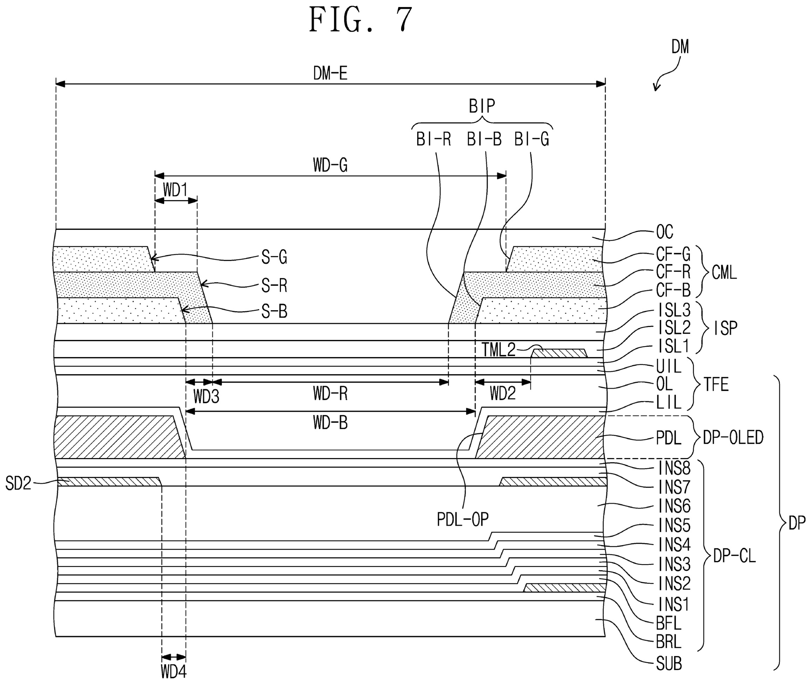

Hereinafter, the transmission hole BIP defined in the transmission region DM-E will be described with reference to FIG. 7.

FIG. 7 is a cross-sectional view of a region corresponding to a transmission hole in the display module according to an embodiment of the inventive concept.

Referring to FIG. 7, in a region including the transmission hole BIP in the transmission region DM-E, a base layer SUB and insulating layers included in the display panel DP, sensing insulating layers included in the input sensing layer ISP, color filters included in the color filter layer CML, and an overcoat layer OC may be disposed as described in FIG. 6. The description overlapping with what is described in FIG. 6 will be omitted.

In a region including the transmission hole BIP in the transmission region DM-E, the barrier layer BRL to the eighth insulating layer INS8 may be disposed on the base layer SUB. On the seventh insulating layer INS7, a conductive pattern SD2 including the same material and patterned by the same process as the second connection electrode CNE2 described in FIG. 6 may be disposed.

The eighth insulating layer INS8 may be disposed on the seventh insulating layer INS7, and the pixel defining film PDL including the opening PDL-OP may be disposed on the eighth insulating layer INS8. The light-emitting element OLED may be disposed in any one of the openings PDL-OP provided in plurality, and the light-emitting element OLED may not be disposed in the opening PDL-OP overlapping e.g. at least partially aligned with the transmission hole BIP.

The encapsulation layer TFE may be disposed on the pixel defining film PDL. The input sensing layer ISP may be disposed on the encapsulation layer TFE, and the color filter layer CML may be disposed on the input sensing layer ISP. The overcoat layer OC may be disposed on the color filter layer CML.

According to the present disclosure, the transmission hole BIP in the transmission region DM-E may be defined by the first to third color filters CF-R, CF-B, and CF-G included in the color filter layer CML.

According to this embodiment, the second color filter CF-B may be disposed directly on the input sensing layer ISP overlapping the pixel defining film PDL. The second color filter CF-B may be a pattern that transmits blue light. The second color filter CF-B may include a second hole BI-B that constitutes the transmission hole BIP. The second hole BI-B may be defined by a second side surface S-B of the second color filter CF-B.

The first color filter CF-R may be disposed on the second color filter CF-B. The first color filter CF-R may cover the second upper surface and the second side surface S-B of the second color filter CF-B. The first color filter CF-R may be a pattern that transmits red light. The first color filter CF-R may include a first hole BI-R that constitutes the transmission hole BIP. The first hole BI-R may be defined by a first side surface S-R of the first color filter CF-R.

The third color filter CF-G may be disposed on the first color filter CF-R. The third color filter CF-G may be disposed on the first upper surface of the first color filter CF-R. The third color filter CF-G may expose a portion of the first upper surface of the first color filter CF-R. In this embodiment, a width WD1 of the portion of the first upper surface of the first color filter CF-R exposed from the third color filter CF-G may be about 1 µm to about 2 µm.

The third color filter CF-G may be a pattern that transmits green light. The third color filter CF-G may include a third hole BI-G that constitutes the transmission hole BIP. The third hole BI-G may be defined by a third side surface S-G of the third color filter CF-G.

According to this embodiment, a first width WD-R of the first hole BI-R may be smaller than a second width WD-B of the second hole BI-B and a third width WD-G of the third hole BI-G. The second width WD-B of the second hole BI-B may be smaller than the third width WD-G of the third hole BI-G.

Therefore, the transmission hole BIP in the transmission region DM-E may correspond to the first side surface S-R of the first color filter CF-R that transmits red light. Accordingly, the first width WD-R of the first hole BI-R defined by the first side surface S-R of the first color filter CF-R may correspond to the width of the transmission hole BIP, and the first width WD-R of the first hole BI-R may be about 5 µm to about 14 µm.

According to the present disclosure, the third sensing insulation layer ISL3 of the input sensing layer ISP may be exposed from the color filter layer CML by the transmission hole BIP. A portion of the third sensing insulation layer ISL3 exposed by the transmission hole BIP may be in contact with the overcoat layer OC.

The overcoat layer OC may be disposed inside the transmission hole BIP, and the side surfaces S-R, S-B, and S-G of the first to third color filters CF-R, CF-B, and CF-G may be in contact with the overcoat layer OC.

On a cross section, the first side surface S-R of the first color filter CF-R may protrude further inward of the transmission hole BIP than the side surface of the second conductive layer TML2 of the input sensing layer ISP. According to an embodiment of the inventive concept, a width WD2 between the side surface of the second conductive layer TML2 and the first side surface S-R of the first color filter CF-R may be about 1 µm to about 4 µm.

On a cross section, the first side surface S-R of the first color filter CF-R may protrude further inward of the transmission hole BIP than the side surface of the pixel defining film PDL. Accordingly, the first width WD-R may be smaller than the width of the opening PDL-OP. According to an embodiment of the inventive concept, a width WD3 between the side surface of the pixel defining film PDL defining the opening PDL-OP and the first side surface S-R of the first color filter CF-R may be about 1 µm to about 2 µm.

On a cross section, a width WD4 between the side surface of the pixel defining film PDL and the side surface of the conductive pattern SD2 may be about 1 µm to about 2 µm.

According to the present disclosure, by forming the transmission hole BIP passing through the first to third color filters CF-R, CF-B, and CF-G in the transmission region DM-E, it is possible to provide the electronic device ED in which the transmission region DM-E has a higher light transmittance than an adjacent active region DM-AA. Accordingly, even though the electronic module EM is disposed below the active region DM-AA, it is possible to resolve the issue of degradation in the performance of the electronic module EM and omit a separate space for placing the electronic module EM in the peripheral region DM-NAA. Accordingly, the electronic device ED having a reduced peripheral region DM-NAA may be provided.

In addition, as the transmission hole BIP is defined within the transmission region DM-E by the first side surface S-R of the first color filter CF-R that transmits red light, the first width WD-R of the first hole BI-R may be reduced to about 8 µm or less. By reducing the width of the transmission hole BIP, it is possible to apply the transmission hole BIP according to the present disclosure to a high-resolution display panel DP and define the shape of the transmission hole BIP in various ways.

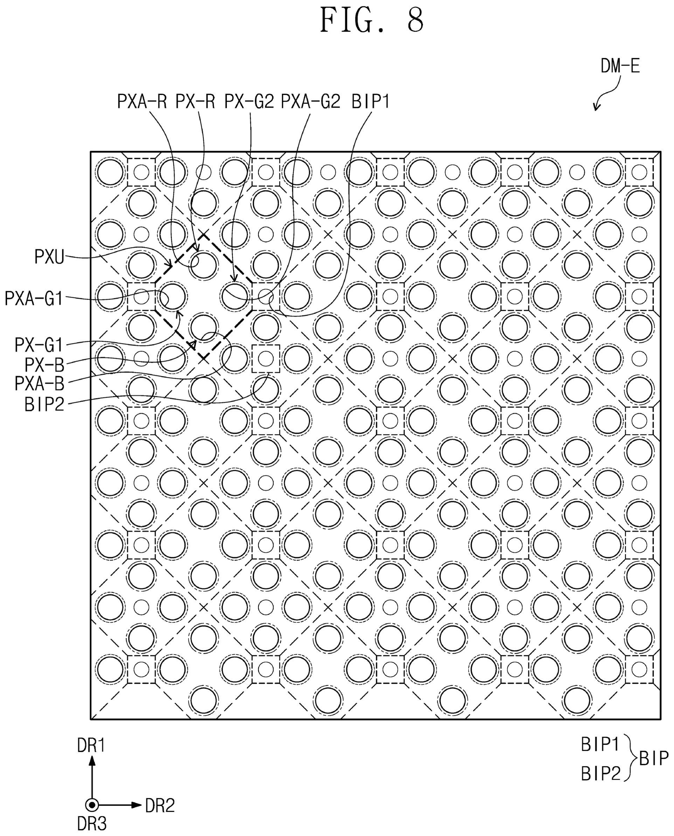

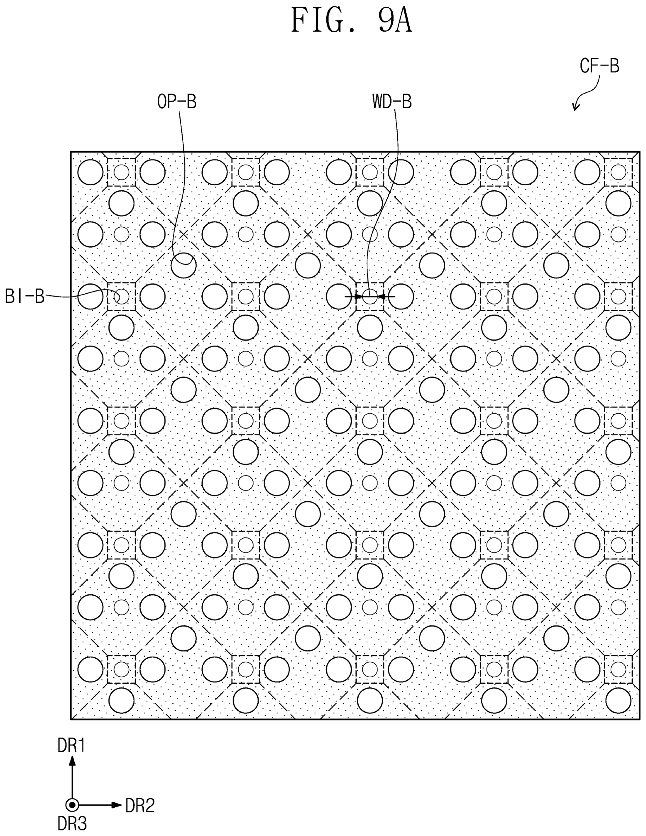

FIG. 8 is a plan view of a transmission region according to an embodiment of the inventive concept. FIGS. 9A to 9C are plan views of a color filter according to an embodiment of the inventive concept.

FIG. 8 illustrates the arrangement relationship of pixel units PXU and transmission holes BIP disposed in the transmission region DM-E. In the active region DM-AA described in FIG. 3, the pixel units PXU excluding the transmission holes BIP may be disposed. According to an embodiment of the inventive concept, the arrangement form and structure of the pixel units PXU disposed in the active region DM-AA may be different from those of the pixel units PXU disposed in the transmission region DM-E.

Referring to FIG. 8, the pixel units PXU arranged along the first direction DR1 and the second direction DR2 may be disposed in the transmission region DM-E. Each of the pixel units PXU may include first to (3-2)-th pixels PX-R, PX-B, PX-G1, and PX-G2 that generate different light.

In FIG. 8, the first electrodes AE (see FIG. 6) included in the first to (3-2)-th pixels PX-R, PX-B, PX-G1, and PX-G2 are illustrated in dotted lines and may be referred to as the first to (3-2)-th pixels PX-R, PX-B, PX-G1, and PX-G2.

The first pixel PX-R may provide red light to a first light-emitting region PXA-R, the second pixel PX-B may provide blue light to a second light-emitting region PXA-B, and the (3-1)-th and (3-2)-th pixels PX-G1 and PX-G2 may provide green light to third light-emitting regions PXA-G1 and PXA-G2. The first to third light-emitting regions PXA-R, PXA-B, PXA-G1, and PXA-G2 may correspond to the light-emitting region PXA described in FIG. 6.

According to this embodiment, the first to third light-emitting regions PXA-R, PXA-B, PXA-G1, and PXA-G2 may be circular. In addition, the areas of the first to third light-emitting regions PXA-R, PXA-B, PXA-G1, and PXA-G2 may be the same as each other. Without being limited thereto, however, the shapes and areas of the first to third light-emitting regions PXA-R, PXA-B, PXA-G1, and PXA-G2 may be different from each other.

In addition, the shapes and areas of the first to third light-emitting regions PXA-R, PXA-B, PXA-G1, and PXA-G2 disposed in the transmission region DM-E may be different from those of the first to third light-emitting regions PXA-R, PXA-B, PXA-G1, and PXA-G2 disposed in the active region DM-AA described in FIG. 3, and the inventive concept is not limited to any one embodiment.

The first pixel PX-R and the second pixel PX-B may be spaced apart from each other along the first direction DR1. The (3-1)-th pixel PX-G1 and the (3-2)-th pixel PX-G2 may be spaced apart from each other along the second direction DR2 with the first pixel PX-R and the second pixel PX-B interposed therebetween.

The transmission holes BIP may be disposed in the transmission region DM-E. The transmission holes BIP may include a first transmission hole BIP1 and a second transmission hole BIP2. The first transmission hole BIP1 may be disposed between adjacent pixel units PXU. For example, the first transmission hole BIP1 may be disposed between four pixel units PXU arranged along the first direction DR1 and the second direction DR2.

The second transmission hole BIP2 may be disposed inside one pixel unit PXU. The first and second transmission holes BIP1 and BIP2 may not be disposed inside another pixel unit PXU. However, the ratio of the transmission holes BIP to the pixel units PXU is not limited thereto.

In FIGS. 9A to 9C, the first to third color filters CF-R, CF-B, and CF-G defining the transmission holes BIP are illustrated as being separated from one another.

Referring to FIG. 9A, the second color filter CF-B may include second openings OP-B and second holes BI-B constituting a portion of the transmission hole BIP. The second openings OP-B and the second holes BI-B may be formed by passing through the second color filter CF-B. The second openings OP-B may be formed on the light-emitting elements OLED that emit light other than blue light, as described in FIG. 6.

The second holes BI-B may constitute a portion of each of the first and second transmission holes BIP1 and BIP2. On a plane, the second hole BI-B may be circular and have the second width WD-B.

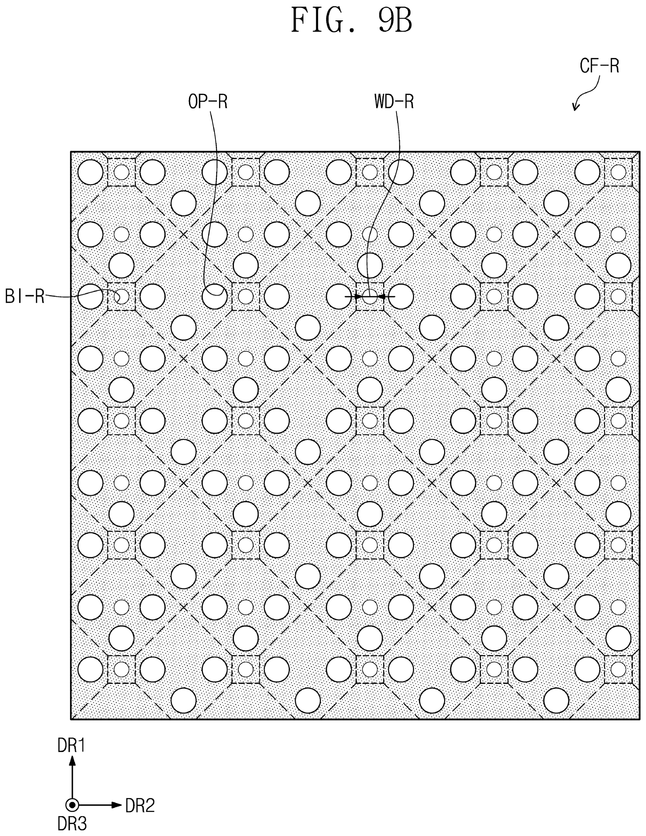

Referring to FIG. 9B, the first color filter CF-R may include first openings OP-R and first holes BI-R constituting a portion of the transmission hole BIP. The first hole BI-R may be at least partially aligned with the second hole BI-B. The first openings OP-R and the first holes BI-R may be formed by passing through the first color filter CF-R. The first openings OP-R may be formed on the light-emitting elements OLED (see FIG. 6) that emit light other than red light.

Together with the second holes BI-B, the first holes BI-R may constitute a portion of each of the first and second transmission holes BIP1 and BIP2. On a plane, the first hole BI-R may be circular and have the first width WD-R. The first width WD-R may be smaller than the second width WD-B. The first width WD-R may be about 5 µm to about 14 µm.

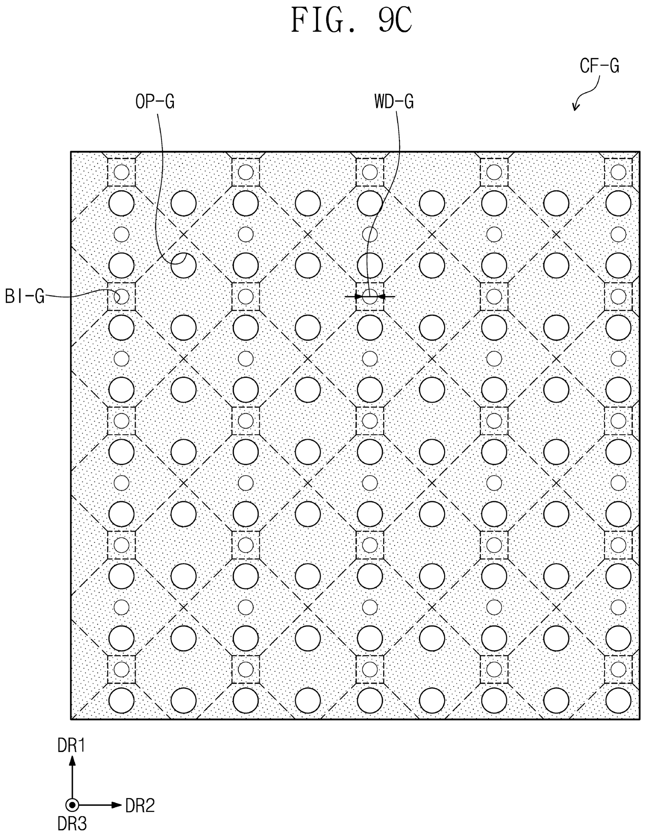

Referring to FIG. 9C, the third color filter CF-G may include third openings OP-G and third holes BI-G constituting a portion of the transmission hole BIP. The third hole BI-G may be at least partially aligned with the first hole BI-R and the second hole BI-B. The third openings OP-G and the third holes BI-G may be formed by passing through the third color filter CF-G. The third openings OP-G may be formed on light-emitting elements OLED that emit light other than green light, as described in FIG. 6.

Together with the first holes BI-R and the second holes BI-B, the third holes BI-R may constitute a portion of each of the first and second transmission holes BIP1 and BIP2. On a plane, the third hole BI-G may be circular and have the third width WD-G. The third width WD-G may be greater than the first width WD-R and equal to or greater than the second width WD-B.

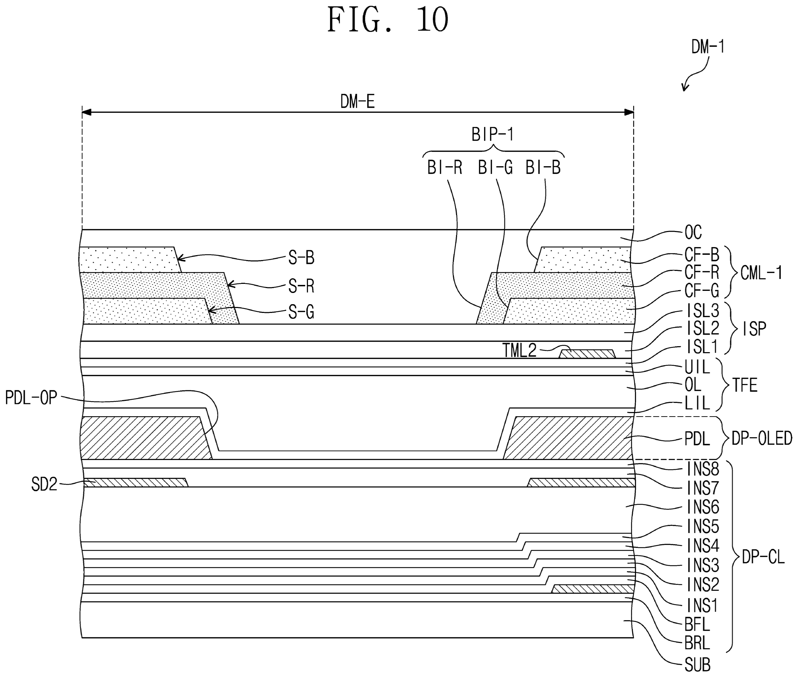

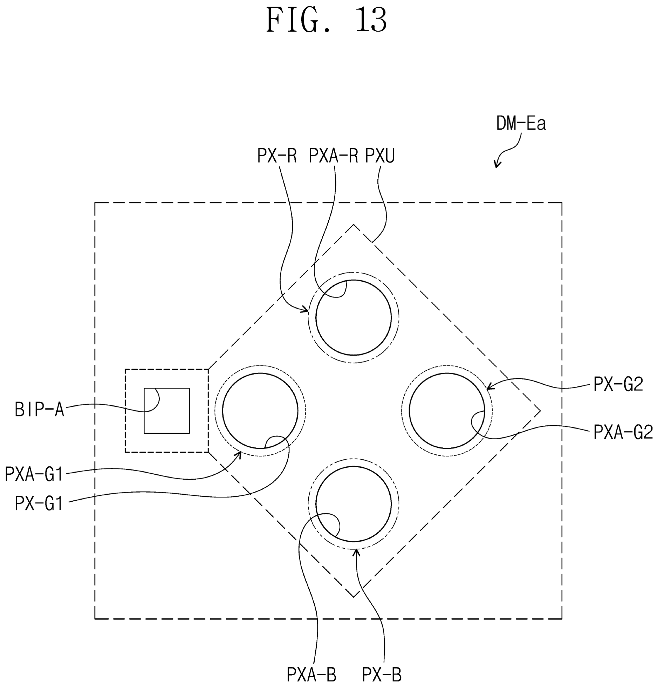

FIGS. 10 to 12 are cross-sectional views of transmission holes in display modules according to an embodiment of the inventive concept. FIG. 13 is a plan view of a pixel unit according to an embodiment of the inventive concept. Identical or similar reference numerals are used for the components that are identical or similar to those described in FIGS. 2A to 9C, and redundant descriptions are omitted.

Referring to FIG. 10, a display module DM-1 according to an embodiment of the inventive concept may include a base layer SUB, insulating layers, sensing insulating layers included in an input sensing layer ISP, color filters included in a color filter layer CML-1, and an overcoat layer OC. Descriptions overlapping with what is described in FIG. 6 will be omitted.

According to the present disclosure, a transmission hole BIP-1 in the transmission region DM-E may be defined by first to third color filters CF-R, CF-B, and CF-G included in the color filter layer CML-1.

According to this embodiment, the third color filter CF-G may be disposed directly on the input sensing layer ISP overlapping the pixel defining film PDL. The third color filter CF-G may be a pattern that transmits green light. The third color filter CF-G may include a third hole BI-G constituting the transmission hole BIP-1. The third hole BI-G may be defined by the third side surface S-G of the third color filter CF-G.

The first color filter CF-R may be disposed on the third color filter CF-G. The first color filter CF-R may cover the third upper surface and the third side surface S-G of the third color filter CF-G. The first color filter CF-R may be a pattern that transmits red light. The first color filter CF-R may include a first hole BI-R constituting the transmission hole BIP-1. The first hole BI-R may be defined by the first side surface S-R of the first color filter CF-R.

The second color filter CF-B may be disposed on the first color filter CF-R. The second color filter CF-B may be disposed on the first upper surface of the first color filter CF-R. The second color filter CF-B may expose a portion of the first upper surface of the first color filter CF-R.

The second color filter CF-B may be a pattern that transmits blue light. The second color filter CF-B may include a second hole BI-B constituting the transmission hole BIP-1. The second hole BI-B may be defined by the second side surface S-B of the second color filter CF-B.

According to this embodiment, the width of the first hole BI-R may be smaller than the widths of the second hole BI-B and the third hole BI-G.

Therefore, the transmission hole BIP-1 in the transmission region DM-E may correspond to the first side surface S-R of the first color filter CF-R that transmits red light. Accordingly, the width of the first hole BI-R defined by the first side surface S-R of the first color filter CF-R may correspond to the width of the transmission hole BIP-1, and the width of the first hole BI-R may be about 5 µm to about 14 µm.

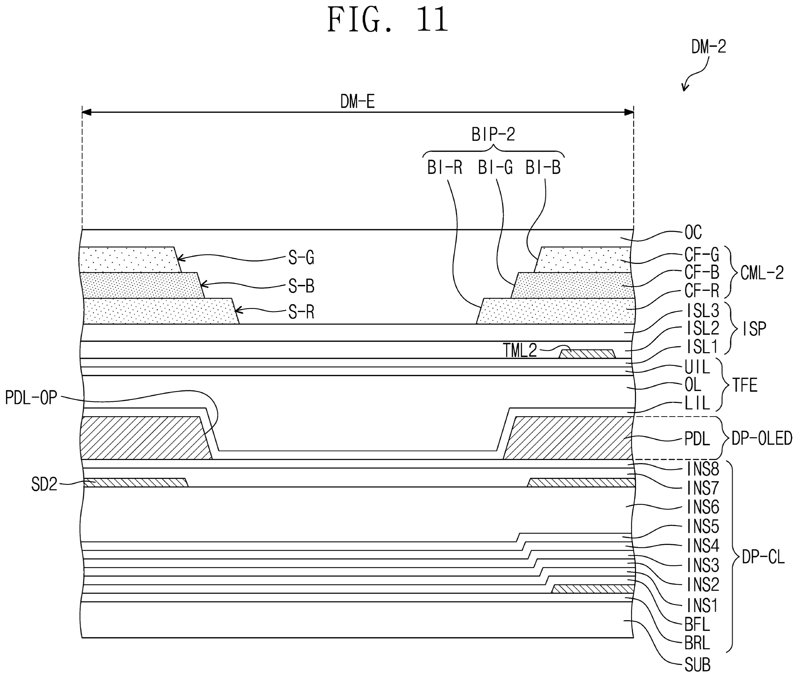

Referring to FIG. 11, a display module DM-2 according to an embodiment of the inventive concept may include a base layer SUB, insulating layers, sensing insulating layers included in an input sensing layer ISP, color filters included in a color filter layer CML-2, and an overcoat layer OC. Descriptions overlapping with what is described in FIG. 6 will be omitted.

According to the present disclosure, a transmission hole BIP-2 in the transmission region DM-E may be defined by first to third color filters CF-R, CF-B, and CF-G included in the color filter layer CML-2.

According to this embodiment, the first color filter CF-R may be disposed directly on the input sensing layer ISP overlapping the pixel defining film PDL. The first color filter CF-R may include a first hole BI-R constituting the transmission hole BIP-2. The first hole BI-R may be defined by the first side surface S-R of the first color filter CF-R.

The second color filter CF-B may be disposed on the upper surface of the first color filter CF-R, and a portion of the upper surface of the first color filter CF-R may be exposed from the second color filter CF-B. The second color filter CF-B may include a second hole BI-B constituting the transmission hole BIP-2. The second hole BI-B may be defined by the second side surface S-B of the second color filter CF-B.

The third color filter CF-G may be disposed on the upper surface of the second color filter CF-B, and a portion of the upper surface of the second color filter CF-B may be exposed from the third color filter CF-G. The third color filter CF-G may include a third hole BI-G constituting the transmission hole BIP-2. The third hole BI-G may be defined by the third side surface S-G of the third color filter CF-G.

According to an embodiment of the inventive concept, the width of the first hole BI-R may be smaller than the widths of the second hole BI-B and the third hole BI-G.

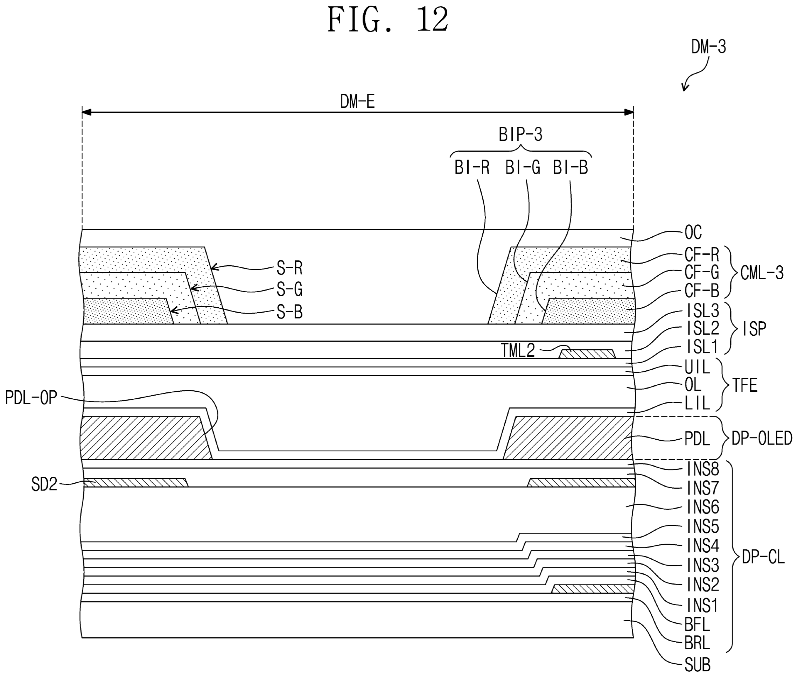

Referring to FIG. 12, a display module DM-3 according to an embodiment of the inventive concept may include a base layer SUB, insulating layers, sensing insulating layers included in an input sensing layer ISP, color filters included in a color filter layer CML-3, and an overcoat layer OC. Descriptions overlapping with those described in FIG. 6 will be omitted.

According to the present disclosure, a transmission hole BIP-3 in the transmission region DM-E may be defined by first to third color filters CF-R, CF-B, and CF-G included in the color filter layer CML-3.

According to this embodiment, the second color filter CF-B may be directly disposed on the input sensing layer ISP overlapping the pixel defining film PDL. The second color filter CF-B may include a second hole BI-B constituting the transmission hole BIP-3.

The third color filter CF-G may be disposed on the second color filter CF-B. The third color filter CF-G may cover the second upper surface and the second side surface S-B of the second color filter CF-B. The first color filter CF-R may be a pattern that transmits red light. The third color filter CF-G may include a third hole BI-G constituting the transmission hole BIP-3.

The first color filter CF-R may be disposed on the third color filter CF-G. The first color filter CF-R may cover the third upper surface and the third side surface S-G of the third color filter CF-G and the second side surface S-B of the second color filter CF-B. The first color filter CF-R may be a pattern that transmits red light. The first color filter CF-R may include a first hole BI-R constituting the transmission hole BIP-3.

Referring to FIG. 13, a transmission region DM-Ea according to an embodiment of the inventive concept may include a pixel unit PXU and a transmission hole BIP-A adjacent to the pixel unit PXU. The pixel unit PXU may include first to (3-2)-th pixels PX-R, PX-B, PX-G1, and PX-G2 that generate different light. The shapes of the first to third light-emitting regions PXA-R, PXA-B, PXA-G1, and PXA-G2, through which light generated from the first to (3-2)-th pixels PX-R, PX-B, PX-G1, and PX-G2 passes, may be circular.

According to this embodiment, the shape of the transmission hole BIP-A may be different from the shapes of the first to third light-emitting regions PXA-R, PXA-B, PXA-G1, and PXA-G2. According to an embodiment of the inventive concept, the shape of the transmission hole BIP-A may be a square. Without being limited thereto, however, the transmission hole BIP-A may have a polygonal shape.

According to an embodiment of the inventive concept, as a transmission hole is defined within the transmission region by the side surface of the color filter that transmits red light, the width of the transmission hole may be formed to be below a certain value. By reducing the width of the transmission hole, it is possible to apply the transmission hole to a high-resolution display panel and define the shape of the transmission hole in various ways.

Although the above has been described with reference to embodiments of the inventive concept, those skilled in the art or those of ordinary skill in the art will understand that various modifications and changes can be made to the inventive concept within the scope that does not depart from the technical scope of the present disclosure as determined by the appended claims. Accordingly, the technical scope of the inventive concept should not be limited to the content described in the detailed description of the specification, but is determined by the appended claims.

## Claims

1. An electronic device (10, ED, ED-a) comprising:
a display panel (DP) comprising:
a base layer (SUB) including an active region (DM-AA), a transmission region (DM-E, DM-Ea) surrounded by the active region (DM-AA), and a peripheral region (DM-NAA) adjacent to the active region (DM-AA),
a pixel unit (PXU) disposed on the base layer (SUB) and including pixels (PX), each pixel (PX) of the pixels (PX) including a transistor (T) and a light-emitting element (OLED) connected to the transistor (T),
a pixel defining film (PDL) including openings (PDL-OP), wherein any one of the openings (PDL-OP) is around at least a portion of a first electrode (AE) included in the light-emitting element (OLED), and
an encapsulation layer (TFE) covering the pixels (PX);
a driving unit mounted on the display panel (DP) and transmitting an electrical signal to the display panel (DP);
an input sensing layer (ISP) disposed on the encapsulation layer (TFE); and
a color filter layer (CML) disposed on the input sensing layer (ISP) and comprising first to third color filters (CF-R, CF-B, CF-G) configured to transmit light of different colors,
wherein:
the first to third color filters (CF-R, CF-B, CF-G) include first to third holes (BI-R, BI-B, BI-G) respectively defining a transmission hole (BIP) that is around at least a portion of the input sensing layer (ISP) in the transmission region (DM-E); and
a first width (WD-R) of the first hole (BI-R) of the first color filter (CF-R) configured to transmit red light is smaller than a second width (WD-B) of the second hole (BI-B) of the second color filter (CF-B) configured to transmit blue light and a third width (WD-G) of the third hole (BI-G) of the third color filter (CF-G) configured to transmit green light.

2. The electronic device (10, ED, ED-a) of claim 1, wherein:
the first color filter (CF-R) covers an upper surface of the second color filter (CF-B) and a second side surface (S-B) of the second color filter (CF-B), which defines the second hole (BIB); and
the third color filter (CF-G) is disposed on an upper surface of the first color filter (CF-R) and exposes a portion of the upper surface of the first color filter (CF-R),
wherein the exposed portion of the upper surface of the first color filter (CF-R) has preferably a fourth width (WD1) of about 1 µm to about 2 µm.

3. The electronic device (10, ED, ED-a) of claim 1, wherein:
the first color filter (CF-R) covers an upper surface of the third color filter (CF-G) and a third side surface (S-G) of the third color filter (CF-G), which defines the third hole (BI-G); and
the second color filter (CF-B) is disposed on an upper surface of the first color filter (CF-R) and exposes a portion of the upper surface of the first color filter (CF-R).

4. The electronic device (10, ED, ED-a) of claim 1, wherein:
the second color filter (CF-B) is disposed on an upper surface of the first color filter (CF-R) and exposes a portion of the upper surface of the first color filter (CF-R); and
the third color filter (CF-G) is disposed on an upper surface of the second color filter (CF-B) and exposes a portion of the upper surface of the second color filter (CF-B).

5. The electronic device (10, ED, ED-a) of claim 1, wherein:
the third color filter (CF-G) is disposed on the second color filter (CF-B);
the first color filter (CF-R) is disposed on the second color filter (CF-B); and
the first color filter (CF-R) covers a second side surface (S-B) of the second color filter (CF-B), wherein the second side surface (S-B) of the second filter (CF-B) defines the second hole (BI-B), and a third side surface (S-G) of the third color filter (CF-G), wherein the third side surface (S-G) of the third color filter (CF-G) defines the third hole (BI-G).

6. The electronic device (10, ED, ED-a) of any one of claims 1 to 5, wherein the first width (WD-R) of the first hole (BI-R) is about 5 µm to about 14 µm.

7. The electronic device (10, ED, ED-a) of any one of claims 1 to 6, wherein:
the light-emitting element (OLED) is not disposed in an opening (PDL-OP) at least partially aligned with the transmission hole (BIP) among the openings (PDL-OP); and
a sixth width (WD-3) between a side surface of the pixel defining film (PDL), which defines the opening (PDL-OP) at least partially aligned the transmission hole (BIP), and a first side surface (S-R) of the first color filter (CF-R), which defines the first hole (BI-R), is about 1 µm to about 2 µm.

8. The electronic device (10, ED, ED-a) of any one of claims 1 to 7, wherein, on a plane, the transmission hole (BIP) has a shape of either a circle or a polygon and/or the openings (PDL-OP) are circular.

9. The electronic device (10, ED, ED-a) of any one of claims 1 to 8, wherein the pixels (PX) included in the pixel unit (PXU) comprise:
a first pixel (PX-R) configured to generate the red light;
a second pixel (PX-B) configured to generate the blue light; and
a (3-1)-th pixel (PX-G1) and a (3-2)-th pixel (PX-G2) configured to generate the green light.

10. The electronic device (10, ED, ED-a) of claim 9, wherein:
the first pixel (PX-R) and the second pixel (PX-B) are spaced apart from each other along the first direction (DR1); and
the (3-1)-th pixel (PX-G1) and the (3-2)-th pixel (PX-G2) are spaced apart from each other along a second direction (DR2) crossing the first direction (DR1) with the first pixel (PX-R) and the second pixel (PX-B) interposed therebetween.

11. The electronic device (10, ED, ED-a) of claim 10, wherein:
the pixel unit (PXU) is provided in plurality, and
the pixel units (PXU) are arranged along the first direction (DR1) and the second direction (DR2); and/or
a first transmission hole (BIP1) of the transmission holes (BIP) is disposed between two pixel units (PXU) adjacent thereto along the first direction (DR1) and the second direction (DR2), and
a second transmission hole (BIP2) of the transmission holes (BIP) is disposed inside one pixel unit (PXU).

12. The electronic device (10, ED, ED-a) of any one of claims 9 to 11, wherein:
the first color filter (CF-R) is disposed on the first pixel (PX-R),
the second color filter (CF-B) is disposed on the second pixel (PX-B), and
the third color filter is disposed on the (3-1)-th pixel (PX-G1) and (3-2)-th pixel (PX-G2); and/or
the first to third color filters (CF-R, CF-B, CF-G) are stacked on the input sensing layer (ISP) overlapping the pixel defining film (PDL).

13. The electronic device (10, ED, ED-a) of any one of claims 1 to 12, wherein the encapsulation layer (TFE) comprises:
a first inorganic layer (LIL) covering the light-emitting elements (OLED);
a second inorganic layer (UIL) disposed above the first inorganic layer (LIL); and
an organic layer (OL) disposed between the first inorganic layer (LIL) and the second inorganic layer (UIL).

14. The electronic device (10, ED, ED-a) of any one of claims 1 to 13, wherein the input sensing layer (ISP) comprises:
a first sensing insulating layer (ISL1) directly disposed on the second inorganic layer (UIL);
a first conductive layer (TML1) disposed on the first sensing insulating layer (ISL1);
a second sensing insulating layer (ISL2) disposed on the first sensing insulating layer (ISL1) and covering the first conductive layer (TML1);
a second conductive layer (TML2) disposed on the second sensing insulating layer (ISL2); and
a third sensing insulating layer (ISL3) disposed on the second sensing insulating layer (ISL2) and covering the second conductive layer (TML2).

15. The electronic device (10, ED, ED-a) of any one of claims 1 to 14, further comprising:
an overcoat layer (OC) disposed on the color filter layer (CML) and in contact with the input sensing layer (ISP) exposed by the transmission hole (BIP); and/or
an electronic module (EM) disposed below the transmission region (DM-E), wherein the electronic module (EM) comprises at least any one of a camera, a speaker, a light sensor, or a heat sensor.
